# EUROPEAN PATENT SPECIFICATION

(11) **EP 4 113 140 B1**
(45) Date of publication and mention of the grant of the patent: **09.10.2024**
(21) Application number: 21183301.7
(22) Date of filing: 01.07.2021
(51) Int. Cl.: G01R 31/382, H01M 10/48

(54) **BATTERY FAULT DETERMINATION**
BATTERIEFEHLERBESTIMMUNG
DÉTERMINATION DE DÉFAILLANCE DE BATTERIE

(43) Date of publication of application: 04.01.2023
(73) Proprietor: Dukosi Limited, Edinburgh EH3 8RA (GB)
(72) Inventor: CRYMBLE, Timothy, Edinburgh, EH14 4AP (GB); JONES, Adrian, Edinburgh, EH14 4AP (GB); LEWORTHY, Josh Robert, Edinburgh, EH14 4AP (GB); SYLVESTER, Joel, Edinburgh, EH14 4AP (GB)
(74) Representative: Finnegan Europe LLP

(56) References cited:
- WO-A1-2015/139927
- WO-A1-2020/242131
- US-A1- 2020 235 441
- US-B1- 10 992 149

## Description

### Technical Field

The present disclosure relates to the field of battery technology and energy cells. In particular, disclosed embodiments relate to methods, systems, and devices for monitoring a state of a battery system, its battery cells, or both and detecting faults arising at the battery system, battery cells, or both.

### Background

Battery systems including a plurality of battery cells are used in a wide range of modern electric power applications. For example, battery systems are used in industrial applications (such as transportation, e.g., powering electric vehicles and power grids) and commercial applications (e.g., powering electronic devices, including laptop computers, mobile devices, medical devices, etc.). Given the relatively high-power demands of such applications, a battery system often includes a plurality of battery cells coupled together in series, parallel, or mixture of both, to achieve a required power output. Battery cells may be coupled together to form a battery pack, where the battery system may include one or more battery packs.

Some battery cells contain a flammable electrolyte, and thus can be dangerous under certain conditions. For example, battery cells may become damaged if they are overcharged above a certain voltage or if they exceed a certain temperature. If then further overcharged, such battery cells may go into thermal runaway. Battery cells may also become damaged if discharged below a certain voltage.

Also, the lifetime of battery cells can be reduced if they are discharged at a too high current or if they are charged too quickly.

Safe use of a battery system therefore requires operating the battery system within its Safe Operating Area (SOA). The SOA is often defined as voltage, current, and temperature conditions within which the cells of the battery system are expected to operate without becoming damaged or creating a hazard to the battery system's operator.

To facilitate effective use of a battery system, a lesser constraint than the SOA, i.e., a Normal Operating Area (NOA), may also be defined and enforced at the battery system, e.g., using corresponding voltage, current, and temperature conditions defined for the battery cells. Breaching the NOA is expected to reduce capacity of cells in the battery system, lifetime of cells in the battery system, or both, overtime.

In multi-cell configurations, unevenness of charge and discharge that can arise between cells and battery packs of the battery system may present an additional challenge to the safe and effective use of the battery system.

It is common to connect a battery system to a battery management system (BMS) for monitoring and managing performance of the battery system to ensure its safe and effective operation. BMS measures properties of battery cells in the battery system (e.g., voltage, current, and temperature) and evaluates the measurements to determine the state of the battery system and identify faulty operation of the battery system before a catastrophic fault occurs. For example, the BMS may evaluate the measurements to confirm that the battery cells operate within the SOA using an analytical model of the battery system defined based on manufacturing specification of the battery cells.

BMS may also calculate various secondary data, control environment of the battery system, and balance the battery system.

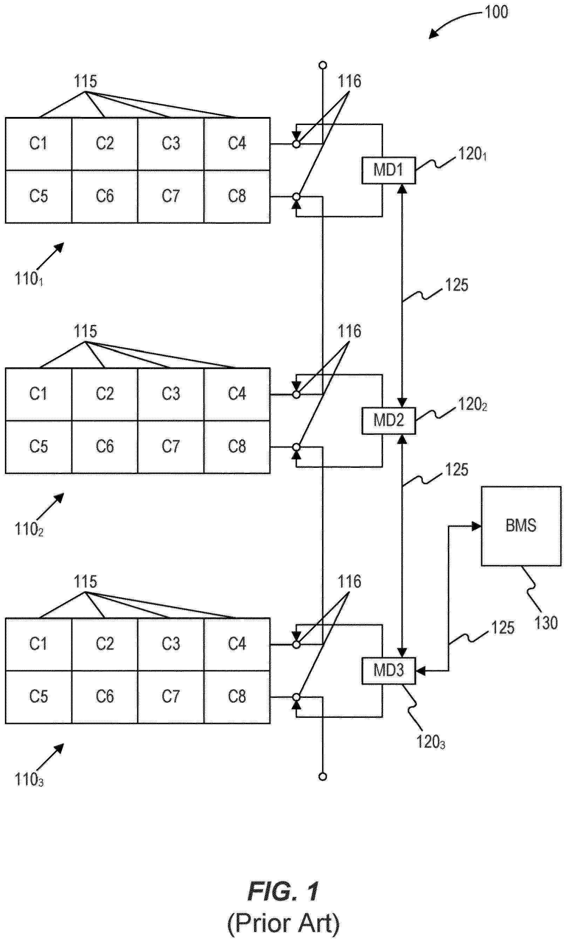

Figure 1 is a schematic illustration of a known battery system 100 comprising a plurality of battery packs 110₁, 110₂, 110₃. Each pack includes a plurality of battery cells 115. Within each battery pack 110₁, 110₂, 110₃, cells 115 are connected in series. Each battery pack 110₁, 110₂, 110₃ includes terminals 116 enabling electrical power to be drawn from battery packs 110₁, 110₂, 110₃.

Each battery pack 110₁, 110₂, 110₃ respectively has measuring device (MD) 120₁, 120₂, 120₃. Each MDs 120₁, 120₂, 120₃ includes an array of sensors configured to measure properties (may also be referenced as performance characteristics) of respective battery pack 110₁, 110₂, 110₃, for example, voltage, current, and temperature of battery cells 115. In the example of Figure 1, battery pack 110₁, 110₂, 110₃ are arranged to power MDs 120₁, 120₂, 120₃ through respective terminals 116.

Battery system 100 also includes BMS 130 connected to battery packs 110₁, 110₂, 110₃. In battery system 100, BMS 130 is a master device, while MDs 120₁, 120₂, 120₃ are slave devices. MDs 120₁, 120₂, 120₃ are coupled in series (daisy chained) forming communication channel 125 terminating at BMS 130.

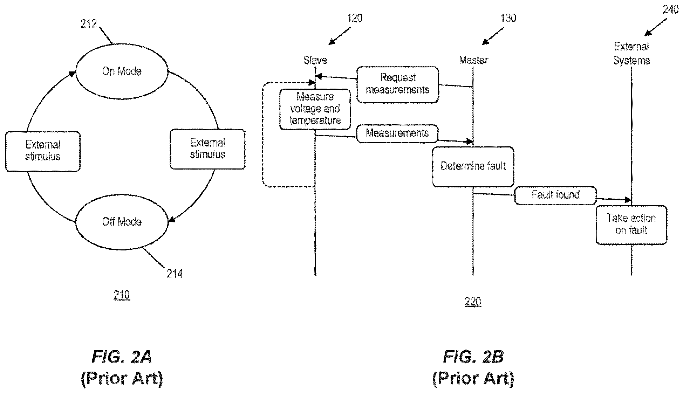

As shown in Figure 2A, BMS 130 may have two operating modes: ON mode 212 and OFF mode 214. For example, powering up battery system 100 in an electric vehicle would power up BMS 130, thereby activating ON mode 212. Powering down battery system 100 would power down BMS 130, deactivating ON mode 212, and thereby placing BMS 130 in OFF mode 214.

With reference to Figure 2B, while in ON mode 212, BMS 130 controls MDs 120 to measure properties of respective cells 115, e.g., voltage and temperature. BMS 130 evaluates the measurements provided by MDs 120 to determine the state of respective battery pack 110, including faults, if any, and reports the state of battery packs 110, including detected fault(s), to external system 240 for possible remedial action(s).

While in OFF mode 214, BMS 130 and MDs 120 are inactive. BMS 130 does not communicate with MDs 120, receive, or evaluate any measurements, or report to external system 240.

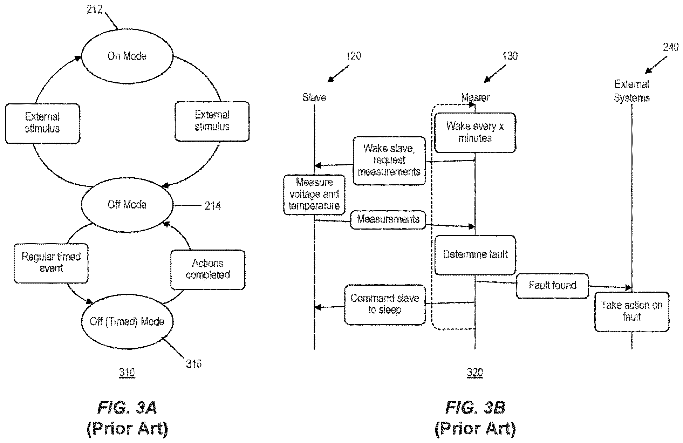

As shown in Figure 3A, in addition to ON and OFF modes 212 and 214, BMS 130 may also have TIMED-OFF mode 316. BMS 130 periodically transitions from OFF mode 214 into TIMED-OFF mode 316. While in TIMED-OFF mode 316, BMS 130 measures and evaluates properties of battery cells 115 using MDs 120. BMS 130 may transition into TIMED-OFF mode 316 while, for example, a respective electric vehicle is powered off. This enables BMS 130 to monitor the state of battery system 100, while preventing drainage of power that would occur if BMS 130 were to remain in ON mode 212 while the electric vehicle is powered off.

With reference to Figure 3B, BMS 130 periodically wakes to transition from OFF mode 214 to TIMED-OFF mode 316 to monitor the state of the battery system. Once in TIMED-OFF mode 316, BMS 130 signals to each MD 120 (e.g., by sending a command) to wake and measure properties of respective cells 115, e.g., voltage and temperature. BMS 130 evaluates the property measurements provided by MDs 120 to determine the state of respective battery packs 110 and whether battery packs 110 experienced any faults, and reports the state of battery packs 110, including any fault(s), to external system 240 for possible remedial action(s). BMS 130 then signals to MDs 120 to transition to sleep state (e.g., by sending a command) and transitions to OFF mode 214. BMS 130 may transition from OFF mode 214 to TIMED-OFF mode 316 at regular intervals, e.g., every 15 minutes.

While in OFF mode 214, BMS 130 is inactive, and thus does not request, receive, or evaluate any measurements of MDs 120. Therefore, if one or more cells 115 develop a fault or experience condition(s) that may result in a fault, e.g., in a delayed fault, BMS 130 may not learn of such a fault or condition while BMS 130 is in OFF mode 214. Further, as MDs 120 do not obtain any measurements while BMS 130 is in OFF mode 214, BMS 130 may not learn of faults, or conditions that could lead to a fault, that developed during OFF mode 214, even after BMS 130 transitions into ON mode 212. Consequently, some faults and conditions leading to faults may remain undetected for prolonged periods of time or not detected at all. WO2016/139927 A1 shows a known method for detecting anomalies in a battery by a battery management system, wherein events are detected with a short circuit sensor which are then evaluated by the battery management system.

### Summary

The invention is defined by the features of the independent claims 1, 17 and 18. Further aspects are defined in the dependent claims.

The method may comprise: the BMS receiving a command to connect the battery to a power source and the BMS checking a status of the battery prior to connecting the battery to the power source. Checking the status of the battery comprises the steps of receiving and processing the fault indicator and the fault data. The method may further include rejecting the command to connect the battery to the power source responsive to a result of processing the received fault indicator and fault data.

The method may also include issuing an alert that the battery is experiencing a fault condition responsive to a result of processing the received fault indicator and fault data.

The fault data may also comprise at least one measurement used by the first CMD to determine the fault. The at least one measurement may comprise one or more of: a measurement obtained at the first cell group, or a measurement derived based on one more measurements obtained at the first cell group, or a combination thereof.

The fault indicator may indicate one or more of: the fault or a severity level of the fault, the severity level being one of an immediate hazard, a delayed hazard, or a degradation hazard.

Processing the received fault indicator and fault data may comprise storing, at the BMS, the fault indicator and the related fault data received from the first CMD.

The method may comprise: receiving, from an external system, a request for a status update of the battery; and transmitting the status update of the battery to the external system, the status update comprising the fault indicator and the related fault data stored at the BMS.

Processing the received fault indicator and fault data may comprise: using one or more cell models with the received fault data to confirm that the first cell group experienced the fault, the one or more models stored at the BMS and corresponding to cells of the first cell group.

Processing the received fault indicator and fault data may comprise: receiving a status update on another cell group (referenced as a "second cell group") in the plurality of cell groups, from a CMD of the second cell group (referenced as a "second CMD"), the status update comprising at least one of: one or more measurements of one or more cell properties of one or more cells in the second cell group obtained by at least one sensor of the second CMD, or fault data related to one or more faults determined by the second CMD at the second cell group, the fault data comprising one or more timestamps indicating when the second CMD respectively determined the one or more faults; and comparing the fault data received from the first CMD with data included in the status update received from the second CMD to confirm that first cell group experienced the fault.

The method may comprise transmitting, upon receiving the fault indicator and fault data from the first CMD, a status request to the second CMD. The status update on the second cell group may be received by the BMS in response to the status request.

The second cell group may comprise one or more cells adjacent to the first cell group.

The method may comprise repeating the receiving and comparing steps for each cell group of the plurality of cell groups.

The BMS may receive the fault indicator indicating that the first CMD determined that first cell group experienced the fault and the related fault data from the first CMD of the first cell group as a part of a status update provided by the first CMD to the BMS. The status update may be received by the BMS periodically, at a prescheduled time, or in response to a status update request sent by the BMS to the first CMD.

The status update by the first CMD may comprise one or more fault indicators and related fault data concerning one or more of: all faults determined by the first CMD at the first cell group since a previous status update received by the BMS from the first CMD, all faults determined by the first CMD at the first cell group during a predefined time period, all faults determined by the first CMD at the first cell group, or one or more faults determined by the first CMD at the first cell group while the BMS was powered off, inactive, or out of communication with the first CMD.

The BMS could be in a sleep mode prior to receiving the fault indicator and the related fault data from the first CMD. The method may comprise: receiving, by the BMS in the sleep mode, an alert signal from the first CMD indicating that the first CMD detected the fault; and responsive to the alert signal, transitioning the BMS from the sleep mode to an active mode to process the fault indicator and related fault data. The fault determined by the first CMD may be classified by the first CMD as an immediate hazard.

The method may comprise, responsive to the alert signal, transmitting a status update request from the BMS to the first CMD, wherein the fault indicator and related fault data may be received from the first CMD responsive to the status update request.

The measurements obtained at the first cell group and received by the BMS as the fault data may comprise one or more of: a voltage detected at the first cell group, a temperature detected externally to the cell group, a temperature at the first cell group, a temperature at a cell or within the cell of the first cell group, a gas pressure within a cell of the first cell group, a force exerted by a cell of the first cell group on an external surface of the cell, a deflection of a cell enclosure of a cell in the first cell group caused by a change of internal pressure, a humidity level at the first cell group or at a cell in the first cell group, a predetermined chemical indicative of cell damage, or a current flowing through the first cell group or through a cell in the first cell group.

The fault determined at the first cell group may be an operational fault or a behavioural fault.

The operational fault may be determined when performance of the first cell group is determined to fall outside of a safe operating area defined by predetermined safe operational limits or outside of a normal operating area defined by predetermined normal operational limits. The safe and normal operational limits correspond to the measurements obtained at the first cell group and may be defined by a cell model corresponding to the first cell group.

The behavioural fault may be determined when performance of the first cell group deviates from expected performance of the first cell group by a deviation greater than a predefined threshold, the expected performance of the first cell group being defined by at least one of: a cell model corresponding to the first cell group or performance of one or more neighbouring cell groups in the plurality of cell groups determined based on measurements obtained by local sensors at the one or more neighbouring cell groups.

The operational fault may be determined when the measurements obtained at the first cell group meet one or more of conditions: a current flowing through the first cell group exceeds a maximum charge current predefined for the one or more battery cells in the first cell group, a current flowing through the first cell group exceeds a maximum discharge current predefined for the one or more battery cells in the first cell group, a temperature taken at the cell group is below a minimum operational temperature predefined for the one or more battery cells in the cell group, the temperature taken at the cell group exceeds a maximum operational temperature predefined for the one or more battery cells in the first cell group, a cell terminal voltage of the one or more battery cells in the cell group exceeds a maximum operational voltage predefined for the one or more battery cells in the cell group, the cell terminal voltage of the one or more battery cells in the cell group is below a minimum operational voltage predefined for the one or more battery cells in the cell group, a cell pressure of the one or more battery cells in the cell group exceeds a maximum operational pressure predefined for the one or more battery cells in the cell group, or a cell pressure of the one or more battery cells in the cell group is below a minimum operational pressure predefined for the one or more battery cells in the cell group.

The behavioural fault may be determined when the measurements obtained at the first cell group meet at least one of the following conditions: a rate of change of temperature at the first cell group is greater or less than a thermo-electrical model of the first cell group for a known stimulus and a current state of the first cell group, or a rate of change of pressure at the first cell group is greater or less than a thermo-electrical model of the first cell group for a known stimulus and a current state of the first cell group, ora rate of change of voltage at the first cell group is greater or less than a thermo-electrical model of the first cell group for a known stimulus and a current state of the first cell group.

The method may comprise: the BMS receiving measurements obtained at one or more cell groups neighbouring the first group by corresponding one or more neighbouring CMDs, where the measurements obtained at the one more neighbouring cell groups correspond to the measurements obtained at the first cell group and are received from the one or more neighbouring CMDs.

The behavioural fault may be determined when a change, or a rate of change, determined in one or more measurements obtained at the first cell group over a period of time deviates from a change, or a rate of change, respectively determined in corresponding one or more measurements obtained at the one or more neighbouring cell groups over the same period of time by a deviation greater than a corresponding threshold, while the first cell group and the one or more neighbouring cell groups are exposed to the same stimulus.

In accordance with another aspect of the present disclosure, there is provided a circuitry configured to execute functions for causing a BMS to perform any of the afore-mentioned methods.

In accordance with yet a further aspect of the disclosure, there is provided a storage medium (e.g., a non-transitory storage medium) storing computer-executable instructions, which when executed on a processor configure the processor to carry out any of the afore-mentioned methods.

In accordance with yet a further aspect of the disclosure, there is provided a computer program product comprising computer-executable instructions which, when executed on a processor, configure the processor to carry out any of the afore-mentioned methods.

### Brief Description of Drawings

The accompanying drawings, which are incorporated in and constitute a part of this disclosure, illustrate disclosed embodiments and, together with the description, serve to explain the disclosed embodiments. In the drawings:
Figure 1 is a schematic illustration of a known battery system.
Figures 2A and 2B depict an example of process flows for a known battery management system with ON and OFF modes.
Figures 3A and 3B depict an example of process flows for a known battery management system with ON, OFF, and Timed-OFF modes.
Figure 4 is a schematic illustration of an exemplary arrangement of a cell monitoring device, in accordance with some disclosed embodiments.
Figures 5A to 5G illustrate examples of operational faults in lithium-ion cell, in accordance with some disclosed embodiments.
Figures 5H to 5N illustrate examples of behavioural faults in lithium-ion cells, in accordance with some disclosed embodiments.
Figure 6 is a schematic illustration of an exemplary arrangement of a cell monitoring device, in accordance with some disclosed embodiments.
Figure 7 is a schematic illustration of an exemplary arrangement of a system for monitoring the state of a battery system, in accordance with some disclosed embodiments.
Figure 8 is a schematic illustration of an exemplary arrangement of a system for monitoring the state of one or more battery systems, in accordance with some disclosed embodiments.
Figure 9 depicts a chart showing operating modes of an exemplary battery management system, in accordance with some disclosed embodiments.
Figure 10 depicts exemplary process flows between a cell monitoring device, a battery management system, an external system, and IOT cloud while the battery management system is operating in ON mode, in accordance with some disclosed embodiments.
Figure 11 depicts exemplary process flows between a cell monitoring device, a battery management system, an external system, and IOT cloud while the battery management system is operating in Safe Sleep mode ON mode and Safe Sleep (polled) mode, in accordance with some disclosed embodiments.
Figure 12 depicts a chart showing exemplary operating modes of a battery management system, in accordance with some disclosed embodiments.
Figures 13 and 14 depict exemplary process flows between a cell monitoring device, a battery management system, an external system, and IOT cloud while the battery management system is operating in Safe Sleep mode and Safe Sleep (alert) mode, in accordance with some disclosed embodiments.
Figure 15 depicts a flowchart of an exemplary method for monitoring the state of a cell group by a cell monitoring device in accordance with some disclosed embodiments.
Figure 16 depicts a flowchart of an exemplary method for monitoring a state of a battery system by a battery management system in accordance with some disclosed embodiments.

### Detailed Description of Embodiments

In the following description, certain aspects and embodiments of the present disclosure will become evident. It should be understood that the disclosure, in its broadest sense, could be practiced without having one or more features of these aspects and embodiments. It should also be understood that these aspects and embodiments are merely exemplary.

The following detailed description refers to the accompanying drawings. Wherever possible, the same or similar reference numbers are used in the drawings and the following description to refer to the same or similar parts or components. While several illustrative embodiments and aspects are described herein, modifications, adaptations and other implementations are possible. For example, substitutions, additions, or modifications may be made to the parts and components illustrated in the drawings, and the illustrative methods described herein may be modified by substituting, reordering, removing, or adding steps to the disclosed methods. Accordingly, the following detailed description is not limited to the disclosed embodiments, aspects, and examples. Instead, the proper scope is defined by the appended claims.

In known battery systems, such as the battery systems discussed with reference to Figures 1, 2A-2B, and 3A-3B, a BMS is able to gain only limited information about the state of health (SoH) of a battery system and its battery cells over time. The BMS may obtain property measurements of a particular battery pack only for those time periods when the BMS is connected to the battery pack and is in communication with the battery pack while in the ON mode or TIMED-OFF mode. The BMS is not able to obtain such measurements for those time periods when the BMS is in the OFF mode, communicates with another battery pack, or is not connected to the battery system. This hinders the BMS ability to accurately identify trends exhibited by cells in battery pack(s), which in turn may prevent the BMS from recognizing faults or conditions that may cause faults in the battery system, or cause the BMS to detect such faults and conditions with a delay.

For example, a sudden spike in temperature at cell(s) in a battery pack, although potentially detrimental to the health of the respective battery pack and battery system as a whole and indicating a fault, may not be detected if the spike occurs while the BMS is in OFF mode 214. A cell or battery pack may reach the temperatures outside its SOA while the BMS is in OFF mode 214, and subsequently cool down before the BMS is switched ON again. Such a fault may potentially provoke a catastrophic chain reaction.

Early identification of such faults would enable issuance of an early warning to the battery operator (e.g., a vehicle driver), facilitate implementation of prompt remedial action(s) that could prevent the faults from rising to a catastrophic level, or both. Using the above example, when a sudden spike temperature at a particular cell or battery pack is detected as it happens or shortly after, preventing charging of the battery system and preventing the start of the vehicle would reduce or prevent propagation of the fault through the battery system, including rising to a catastrophic level (e.g., fire hazard). Replacing the respective cell or battery pack, rather than the entire battery system that is otherwise is functional and operating normally, may then be sufficient to remedy the detected fault.

At least some embodiments of the present disclosure address one or more shortcomings of the prior art systems discussed above with reference to Figures 1 to 3B, providing solutions for monitoring the state of a battery system comprising a plurality of battery cells and detecting faults in such battery cells.

The present disclosure describes methods, systems, and devices for monitoring the state of cells forming a battery system and of the battery system itself and detecting faults arising in such battery cells. The present disclosure provides for a system that includes a battery comprising cell groups, each cell group comprises one or more cells. The system also comprises cell monitoring devices (CMDs) respectively associated with corresponding cell groups, at least one CMD per cell group. Each CMD is operable to measure properties of cells in the respective cell group, using CMD's sensor system, and processes and evaluate such measurements to detect potential faults at the monitored cells, independent of BMS or any external device and notwithstanding whether the CMD is connected to a BMS or is in communication with BMS. CMDs may use one or more cell models calibrated for corresponding cells to enable CMDs to detect faults based on property measurements obtained at the respective cell groups.

A CMD is operable to store data related to the obtained measurements, including any detected fault(s) locally at the CMD for subsequent retrieval, such as responsive to a status update request from BMS or an external device. For example, when the CMD detects a fault, the CMD stores a fault indicator indicating that the cell group associated with (monitored by) the CMD experienced a fault. The CMD also stores fault data related to the detected fault. The fault data at minimum includes a timestamp indicating when the CMD detected the fault. The fault data may also include any data that was relevant or led to the CMD determining the fault. The fault data thus may, for example, include measurements obtained at the cell group, derivatives of such measurements, or a combination of direct and derivative measurements that led the CMD to determine the fault.

An indicator that a CMD detected a fault is stored at the CMD with relevant timing information and available for subsequent retrieval, such as in response to a BMS performing a check on monitored cells before closing a battery system relay to connect the monitored battery system to a power source, such as a charger, or a load such as a powertrain. The BMS therefore becomes aware that a particular cell or cells experienced a fault, while the BMS was incommunicado (out of communication with the CMD), before closing the battery system relay, and thus allows for implementation of remedial measures before the fault triggers a catastrophic chain reaction, such as a thermal runaway.

By enabling and employing CMDs to monitor cell states of associated cells, independent of BMS or any other external systems, such as when a BMS is asleep or powered off, and to store relevant data, including concerning any related faults, and by making such data available for subsequent retrieval, methods and systems of this disclosure enable early identification of faults and timely communication of such faults to a respective BMS or an external system. This in turn enables issuance of an early warning to the battery operator (e.g., a vehicle driver), facilitates implementation of prompt remedial action(s) that could prevent the faults from rising to a catastrophic level, or both. For example, when a sudden spike temperature at a particular cell or battery pack is detected as it happens or shortly after, preventing charging of the battery system and preventing the start of the vehicle would reduce or prevent propagation of the fault through the battery system, including from rising to a catastrophic level (e.g., fire hazard).

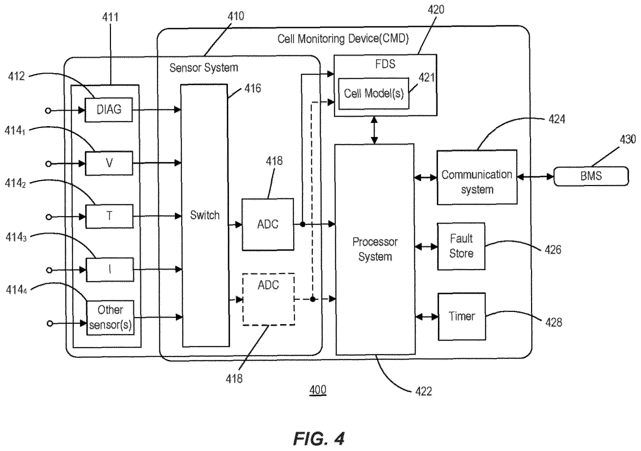

Figure 4 is a schematic illustration of an exemplary arrangement of cell monitoring device (CMD) 400 according to some embodiments. CMD 400 includes sensor system 410, fault detection system (FDS) 420, processor system 422 (may also be referenced as a processing system), communication system 424, fault store 426, and timer or clock 428.

CMD 400 is associated with or connected to one or more battery cells of a battery system to monitor the state of such cells, notwithstanding whether the battery system is connected to battery management system (BMS) 430 or used to operate a particular device or system, such as an electric vehicle. For example, CMD 400 can be used to monitor the state of one or more battery cells while BMS 430 is powered off or otherwise unavailable, such as while a respective battery system is in storage or being shipped, before the battery system is connected to a device or system whose operation the battery system is designed to support, or after the battery system is disconnected from the device or system whose operation the battery system is designed to support.

CMD 400 can be incorporated with a battery cell or attached, permanently or removably, to the battery cell or its components. For example, CMD can be configured for attachment to a flexible pouch of a pouch cell or to a housing of the pouch cell. Additionally or alternatively, CMD 400 can be electrically coupled to one or more terminals of a battery cell, for example to draw power to support functionality of CMD 400.

Multiple CMDs 400 are employed to monitor the status of battery cells forming a battery system. Battery cells are divided into groups, where each group has its own CMD 400. A group of cells includes one or more cells. For example, a group of cells may include a single cell, or a plurality of cells connected in parallel.

In some embodiments, CMD 400 is implemented as an application-specific integrated circuit (ASIC). CMD 400 in the form of an ASIC can be configured to be attached to a battery cell or group of cells, such as to a housing or to one or more components of a battery cell or a group of cells, or be incorporated or integrated with a battery cell or a group of cells.

Sensor system 410 measures properties related to the state of battery cells being monitored by CMD 400, such as physical characteristics of the monitored battery cells, electrical characteristics of the monitored battery cells, chemical characteristics of the monitored battery cells, environmental characteristics that influence the state of the cells, or any combination thereof. Sensor system 410 includes or is connected to a group of sensors 411 related to the monitored cells and configured to obtain measurement of different properties of such cells using sensors 411. Sensor system 410 may also include sensors configured to measure different properties of the cell group's environment.

Group of sensors 411 includes one or more voltage sensors 414i configured to measure voltage at one or more monitored cells and one or more temperature sensors 414₂ configured to measure temperature at one or more monitored cells (e.g., temperature of the one or more monitored cells, temperature of cell surface of the one or more cells, or temperature of the immediate environment of the one of more cells). Group of sensors 411 may also include one or more current sensors 414₃ configured to measure current flowing in or out of one or more monitored cells or a group of cells. Group of sensors 411 may include one or more sensors 414₄ configured to measure other properties of one or more monitored cells, for example, one or more pressure sensors, one or more humidity sensors, or a combination thereof.

A particular sensor 414 may be positioned: within a cell (e.g., within the cell enclosure, such as within a flexible pouch of a pouch cell), on a cell, its component, or its housing, at a cell, e.g., adjacent, or otherwise proximate to a cell or the respective CMD of the cell, or remotely to a cell, depending on what physical, electrical, chemical, or environmental properties of one or more cells that sensor 414 is configured to measure.

For example, a pressure sensor in the form of a gas pressure sensor may be integrated within the cell enclosure, to measure gas pressure within the cell enclosure. A pressure sensor in the form of a strain gauge may be positioned on a cell to monitor the deflection of the cell enclosure caused by a change in the internal pressure of the cell. A current sensor may be positioned at a monitored cell to measure current flowing in, out, or through the cell (e.g., electrically coupled to cell terminals to measure their output). A voltage sensor may be positioned at a monitored cell or a group of monitored cells to measure voltage across terminals of the monitored cell or cell group. A temperature sensor may be integrated with CMD 400 to measure temperature of an immediate environment of the cells monitored by CMD 400. Some sensors 414 may be external to both CMD 400 and cells monitored by CMD 400. For example, CMD 400 may employ a temperature sensor for measuring temperature of a surrounding environment.

Each sensor 414 may be implemented as a combination of one or more sensing elements for measuring corresponding physical, electrical, or chemical cell properties and of signal conditioning circuitry that converts the output of the one or more sensing elements into an analogue signal suitable for conversion by analogue-to-digital converter (ADC) 418. The signal conditioning circuitry can be collocated with the one or more sensing elements or located elsewhere in CMD 400, including externally to the respective cell. For example, only sensing elements can be positioned within a cell, on a cell, or at a cell, depending on what physical, electrical, chemical, or environmental properties such sensing elements are configured to measure, while respective signal conditioning circuitry can be positioned externally to the respective cell.

In some embodiments, group of sensors 411 includes one or more external sensors which are integrated with a corresponding ADC. In these embodiments, the ADC provides respective measurements in a digital form. Such measurement can be shared with FDS 420 and processor system 422 directly, bypassing ADC 418.

Sensor system 410 may also include self-diagnostic sensors 412 to provide reference measurements. By comparing reference measurements with corresponding measurements obtained by sensors 414 for a given stimulus, CMD 400 is able to determine whether measurements obtained by sensors 414 are true to the actual system operation or distorted, for example, due to internal issues with sensors 414.

Sensor system 410 also includes ADC 418 for converting the measurements obtained by sensors 412 and 414 into a digital form and a switch 416 (e.g., a multiplexer) for directing the measurements from sensors 414 to ADC 418 for conversion. ADC 418 outputs the converted measurements to FDS 420, processor system 422, or to both. In some embodiments, switch 416 is integrated into the structure of one or more ADC 418. For example, ADC 418 may have multiple inputs for receiving sensor measurements.

As shown in Figure 4, CMD 400 may include more than one ADC 418. CMD 400 may employ multiple ADCs 418 to implement parallel processing of measurements acquired by sensor system 410. For example, different ADCs may process measurements of different properties. Such parallel processing enables acquisition and processing of time-synchronised measurements of different properties, e.g., voltage and current, thereby improving accuracy with which cell faults can be detected. Parallel processing of measurements may also, or alternatively, be used to improve efficiency with which the measurements are converted into digital form for processing by FDS 420.

Additionally or alternatively, CMD 400 may employ multiple ADC 418 to introduce redundancy within CMD 400. This in turn enhances functional safety of CMD 400, such as in the event of failure by one of ADCs 418.

FDS 420 is operable to evaluate the received measurements to determine if one or more cells monitored by CMD 400 have experienced or are experiencing a fault.

In some embodiments, FDS 420 is implemented in digital logic on an ASIC forming CMD 400. In such implementations, functionality of FDS 420 and cell models 421 are identified at the ASIC design stage.

In some embodiments, FDS 420 is implemented as a processor separate from processor system 422 with separate memory (not shown) and processing defined by firmware. In this implementation, FDS 420 may take the form of a microprocessor or an embedded processor. When FDS 420 is implemented as a separate processor, CMD 400 can be adapted to work with specific cells, or a type of cells post-design and post-manufacturing. No knowledge of cell's chemistry or type is required during design or manufacturing of CMD 400 to ensure full functionality of FDS 420. Additionally, FDS can be reprogrammed after being assembled with a cell group, for example, to modify settings in cell model(s), update cell model(s), or upload new cell model(s).

In some embodiments, a combination of hardware and software is used to implement FDS 420. In such implementations, FDS's processes can be designed using digital logic of an ASIC forming CMD 400, while parameters that would be employed by cell model(s) 421 can be programmed into locally stored tables. This programming can be implemented using different methods. For example, during the production stage or prior to CMD 400 being used with a particular cell or cell group, a metal layer mask made for that cell or cell group's chemistry can be introduced into CMD 400 to configure CMD 400 to work with the cell or cell group. Another example is to introduce one-time programmable memory (e.g., poly fuses) into CMD 400 during the production stage and program such memory with relevant tables prior to using CMD 400 with a cell or cell group. Yet another example is to load chemistry specific tables by processor system 422.

Although Figure 4 shows FDS 420 as a separate component, in some embodiments, FDS 420 is integrated with processor system 422.

FDS 420 employs one or more cell models 421 to evaluate the received measurements for presence of a fault at one or more monitored cells. Cell model 421 receives one or more measurements related to one or more monitored cells as input, evaluates such measurements to determine whether corresponding one or more cells have or are experiencing a fault, and outputs results of the evaluation.

A cell that experienced one or more faults is in a fault condition. As discussed throughout this disclosure, a BMS, such as BMS 430, or an external system, can be operable to determine whether a cell is in a fault condition based on data shared by CMD 400, such as property measurements obtained at the cell by CMD 400, and any faults determined at the cell by CMD 400.

Different cell models 421 may be operable to evaluate respectively different cell properties, different combinations of cell properties, or for different faults. For example, a cell model may be operable to evaluate whether a measurement of a corresponding cell property of a cell exceeds a SOA or a NOA for that cell.

As referenced throughout this disclosure, SOA may be defined as one or more conditions (e.g., voltage, current, temperature, pressure, or any other conditions described in this disclosure), or any combination thereof, within which cells of a battery system are expected to operate without becoming damaged or creating a hazard to the battery system's operator. Similarly, as referenced throughout this disclosure NOA, a lesser constraint than SOA, may be defined as one or more conditions (e.g., voltage, current, temperature, pressure, or any other conditions described in this disclosure), or any combination thereof, within which cells of a battery system are expected to operate without significant (above expected) reduction in capacity, lifetime, or both, overtime.

Additionally or alternatively, FDS 420 may employ one or more cell models 421 each operable to evaluate different cell properties and for different types of faults. For example, a cell model may be operable to evaluate a combination of different properties of a cell to determine whether the cell is operating within its SOA or NOA. FDS 420 may also employ a single cell model configured to determine various kinds of faults that FDS 420 is operable to detect.

In some embodiments, one or more cell models 421 are designed or defined based on manufacturing specification for the monitored cells. Additionally or alternatively, one or more cell models 421 may be defined based on measured properties of the relevant cells at the beginning of their life, such as during initial testing of the cells.

One or more cell models 421 may include one or more numerical cell models, one or more analytical cell models, one or more empirical models, or any combination thereof. One or more cell models 421 may include one or more simple models, one or more complex models, or a combination of both. A simple cell model may check inputted one or more measurements against one or more predefined limits (or thresholds) and flag a fault when the one or more measurements exceed one or more of the predefined limits, e.g., higher or below the one of the predefined limits, or outside predefined limits, or within predefined limits. A more complex cell model may first process the one or more measurements, e.g., by determining one or more derivative measurements and comparing such derivative measurements to one or more thresholds (predefined limits), and then apply filter(s), algorithm(s), or both to determine a fault. A more complex model may also, or instead, set a varying threshold for one or more cell properties (e.g., voltage) based on a measurement of another one or more cell properties (e.g., temperature).

Cell models 421 may be implemented using software, firmware, hardware, or mixture of thereof. For example, checks against thresholds or limits may be implemented in hardware, using analogue or digital comparators, while the threshold or limits themselves may be set and varied by software or firmware. Another example is a cell model designed to integrate the signal from a current sensor over time to provide a coulomb (Amp-seconds) count. The signal integration may be implemented in digital hardware, e.g., using a digital integrator, or in software, e.g., using processor's arithmetical capability.

In some embodiments, FDS 420 is operable to classify detected faults by their severity level. A severity level indicates how urgently a remedial action for addressing the detected fault should be implemented.

FDS 420 may, for example, use three severity levels to classify faults. The first (highest) severity level indicates a fault representing an immediate hazard. Immediate hazard faults include those faults that require an immediate or urgent remedial action. For example, FDS 420 may classify a fault detected based on temperature measurements taken at one or more cells, a rate at which the temperature at the one or more cells has increased, or both, as an immediate hazard fault if the temperature measurements, the rate of temperature increase, or both indicate an imminent thermal event (i.e., fire).

The second (middle) severity level indicates a fault representing a delayed hazard. Delayed hazard faults include those faults that, although result in damage to one or more monitored cells, do not present an immediate danger. For example, FDS 420 may classify a fault detected based on voltage of a cell being under a pre-defined voltage as a delayed hazard fault because the cell is not hazardous until the cell is recharged (e.g., not yet spontaneously flammable).

The third (lowest) severity level indicates a fault representing a degradation hazard. Degradation hazard faults include those faults that do not present an immediate or delayed safety risk to the operation of battery cells or their operator, but can lead to reduced operational capabilities of such battery cells. For example, FDS 420 may classify a single ADC failure as a degradation hazard fault because a single ADC failure does not pose any safety risks, but reduces operational capability of the corresponding cell(s).

In some example embodiments, FDS 420 may upgrade the severity level of a fault detected at a cell group from one severity level to another severity level when multiple faults are detected at the cell group within a certain time period. For example, FDS 420 may detect a delayed hazard fault or degradation fault based on measurements obtained at the cell group, and upgrade the severity level of that fault to the immediate hazard level if the fault is detected following detection of one or more other faults at the cell group within a predefined time period.

In some embodiments, FDS 420 is operable to classify detected faults by their type. A type of fault may indicate a type of remedial action that should be implemented to address the detected fault.

FDS 420 may classify faults into three types: operational faults, behavioural faults, and system faults. Operational faults arise when a cell operates outside its SOA (as defined by safe operating limits) or outside its NOA (as defined by normal operating limits).

When a battery cell operates outside its SOA, the cell safety is compromised and an immediate or delayed hazard may arise, e.g., cell may catch fire. When a cell operates outside its NOA but within its SOA, no hazard is likely to arise. However, breaching the normal operating limits during cell operation is likely to reduce cell's capacity or cell's lifetime over time, beyond expected degradation.

Both SOA and NOA for a battery cell may be defined by setting respective operating limits based on the cell's manufacturing specification. For example, a SOA for a battery cell can be defined as the voltage, current, and temperature conditions within which the battery cell is expected to operate without being damaged or creating a hazard to the operator.

In some example embodiments, safe operating limits, normal operating limits, or both are defined by conditions for measured properties of a cell, e.g., voltage conditions, temperature condition, current conditions, or any combination thereof. Examples of such conditions include but are not limited to a voltage measured at a cell being over or under a pre-defined voltage, or a temperature of a cell being over or under a pre-defined temperature.

In some example embodiments, safe operating limits, normal operating limits, or both are defined using functions of multiple measured properties, calculated parameters, or combination thereof. For example, safe operating limits may be defined as a variable maximum discharge current for a cell that reduces as the state of charge for the cell approaches zero or as the temperature is lowered.

In some example embodiments, safe operating limits, normal operating limits, or both are defined using various combinations of conditions and functions.

Behavioural faults arise when a cell is not operating as expected. For example, a behavioural fault may be detected when behaviour of a particular cell differs from behaviour of neighbouring cells, e.g., its temperature fluctuates more than that of its neighbours, although all detected fluctuations are within safe operating limits and normal operating limits. A behavioural fault may also be detected when a cell responds to a given stimulus differently from what is expected from the cell as, for example, defined by a corresponding model, even though the measured properties of the cell fall within safe operating limits and normal operating limits.

System faults include faults arising within CMD 400 or with attachments to cells monitored by CMD 400. System faults may, for example, be detected based on reference measurements obtained by self-diagnostic sensors 412, when ADC measurement of an internal fixed reference is incorrect, or when an open circuit is detected on voltage sense lines.

CMD 400 may implement various levels of self-testing and self-diagnostic to identify system faults. These include, but are not limited to, ADC operational checks, analogue multiplexer (MUX) operational checks, error correction circuitry on random-access memory (RAM) and flash memory, stack overflow detection, Cyclic Redundancy Check (CRC) in message packets, open circuit detection, watchdog to reset system in event of lock up or runaway operation, identification of communications failure between sub element of CMD 400, or any combination thereof.

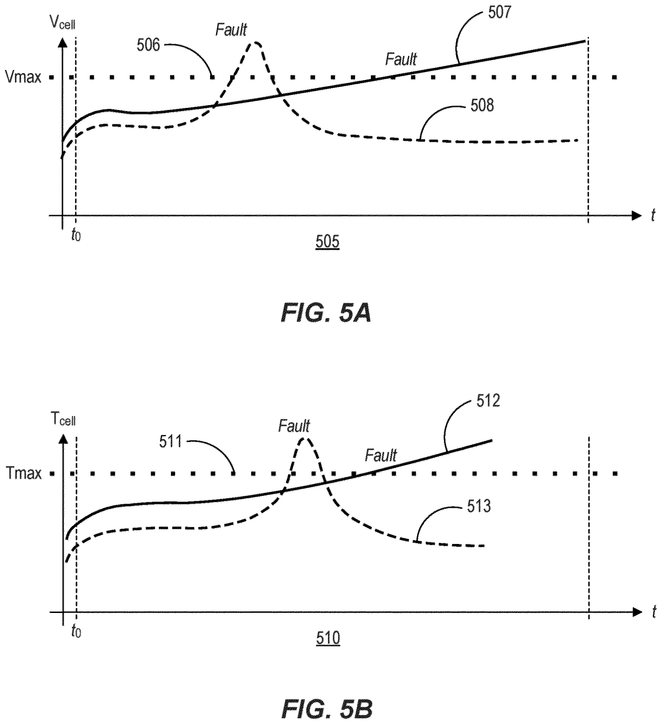

Additional non-limiting examples of faults and related cell models are described with reference to Figures 5A to 5N.

Returning to Figure 4, processor system 422 generally controls operation of CMD 400 and its communication with third parties, such as BMS 430, or an external device or an external system (not shown). Processor system 422 includes at least firmware for executing CPU, RAM, and clocks.

In some embodiments, processor system 422 takes the form of a microcontroller. Additionally or alternatively, processor system 422 may include a microprocessor, a digital signal processor (DSP), an embedded processor, or the like, or may be integrated in a system on a chip (SoC). In some embodiments, processor system 422 includes a processor from the family of processors manufactured by Intel^{®}, AMD^{®}, Qualcomm^{®}, Apple^{®}, NVIDIA^{®}, or the like. Processor system 422 may also be based on the ARM architecture, a mobile processor, etc.

In some embodiments, processor system 422 may be powered down when not in use. Processor system 422 may then be restarted with a signal received from FDS 420, communication system 424, or timer or clock 428.

Communication system 424 enables communication by processor system 422 with BMS 430 or an external device or system. In some embodiments, communication system 424 includes one or more components for enabling communication between CMD 400 and external devices or systems, such as a transceiver, a receiver, a transmitter, or combination thereof. Communication system 424 may support wireless communications, for example, using Bluetooth^{®} or Near Field Communication (NFC) protocols. Alternatively or additionally, communication system 424 may support a wired connection with BMS 430, e.g., USB, CANbus, parallel bus, or another type of wired connection suitable for purpose.

Processor system 422 uses communication system 424 to share the status of the monitored cells, including any detected faults and related fault data, with external systems, such as BMS 430. CMD 400 may share results of fault detection upon FDS 420 completing evaluation of received measurements. In some embodiments, CMD 400 time-shifts, e.g., delays, its communication of a status of the monitored cells, including any detected faults and related fault data, to BMS 430. For example, rather than sharing results, once FDS 420 completes its evaluation of the received measurements, CMD 400 delays communicating the results until a pre-scheduled time or until CMD 400 receives a corresponding request from BMS 430 or an external device or system.

To enable such time-shifting, processor system 422 stores data concerning the status of monitored cells, any faults that FDS 420 detects, and related fault data at fault store 426 for subsequent retrieval along with timing information indicating when, if any, respective faults were detected. Processor system 422 is then able to retrieve relevant data from fault store 426 and share the retrieved data through communication system 424 with a third party, such as BMS 430 that manages a battery system including the cells monitored by CMD 400 and, alternatively or additionally, an external system or device, for example, for subsequent analysis of the SoH history of cells monitored by CMD 400.

Fault store 426 is memory that includes one or more storage devices for storing data concerning faults detected at cells monitored by CMD 400, such as results of evaluation by FDS 420. The one or more storage devices may include, but are not limited to, flash memory (e.g., NOR flash or NAND flash), static random-access memory (SRAM), dynamic random-access memory (DRAM), ferroelectric random-access memory (FRAM), erasable programmable read-on memory (EPROM), electrically erasable programmable read-on memory (EEPROM), non-volatile random-access memory (NVRAM), and/or any other suitable storage device.

Data stored at fault store 426 to capture the state of cells monitored by CMD 400 over time (referenced in this disclosure as cell state data) includes a fault indicator, indicating that a fault has been determined at one or more cells, and data related to the determined fault (referenced in this disclosure as fault data), such as a timestamp of when CMD 400 detected the fault. Cell state data may also include measurements taken at the monitored cells when no fault was detected, derivatives of such measurements, or both, along with information indicating timing of when the measurements were received by FDS 420 or processor system 422 from sensor system 410.

In some embodiments, the fault indicator takes the form of a flag or designated bit (e.g., "0" or "1" designated bit) to indicate that CMD 400 determined a fault.

In some embodiments, the fault indicator is configured to indicate a type of the detected fault (e.g., operational fault, behavioural fault, or a system fault), a severity level of the detected fault (e.g., immediate hazard, delayed hazard, or degradation hazard), the nature of the detected fault (e.g., indicates property(es) that have exceeded their NOA or SOA), or any combination thereof. For example, the fault indicator may include 8 bits, including 2 bits to indicate a severity level of the detected fault or that no fault occurred, 2 bits to indicate a type of the detected fault, and 4 bits to indicate the nature of the detected fault.

In some embodiments, presence of fault data in a message or update from CMD 400 to BMS 430 serves as the fault indicator that CMD 400 detected a fault, while absence of fault data indicates that no fault has been detected.

Fault data includes timing information indicating when FDS 420 detected a fault. For example, the timing information may take the form of a timestamp generated based on output of timer or clock 428 when FDS 420 detected the fault. Fault data may also include measurements (original, derivative, or both) that resulted in FDS 420 detecting the fault, calculations related to detecting the fault, other data related to the fault being detected (e.g., corresponding measurements taken at the cell prior to the fault being detected), or any combination thereof.

When CMD 400 is operable to transmit results of evaluation that FDS 420 performed on the received measurements without time-shifting, such evaluation results include a fault indicator and fault data. These may take the same form as the fault indicator and fault data described as being stored at fault store 426.

Although shown as a separate component in Figure 4, in some embodiments, FDS 420 is integrated with processing system 422.

Figures 5A to 5N illustrate examples of various faults that a CMD according to the present disclosure may detect. The description of these figures references CMD 400 for detecting respective faults. However, other CMD variations discussed throughout this disclosure may be used to detect faults described with reference to Figures 5A to 5N.

As explained with reference to Figure 4, a CMD, such as CMD 400, employs one or more cell models to analyze measurements of cell properties for presence of faults. Some or all of safe and normal operating limits or thresholds discussed with reference to Figures 5A to 5N, or various combinations thereof, may therefore be defined by one or more cell models of CMD 400.

Figures 5A to 5N illustrate examples of operational and behavioural faults in lithium-ion cells. However, similar analysis can be applied to different types of cells, for example, to secondary cell chemistries, such as Li-air, Li-S, NiMH, Lead-Acid, or NiCd, and primary cell chemistries such as alkaline or lithium.

### OPERATIONAL FAULT EXAMPLES

Figures 5A to 5G illustrate examples of operational faults that could be detected by a CMD described in this disclosure.

### Cell Over Voltage Fault

With reference to Figure 5A, when the terminal voltage of a cell exceeds a maximum safe voltage specified by the manufacturing specification of the cell, the cell may become damaged and has the potential to catch fire. Therefore, in some embodiments, CMD 400 is configured to repeatedly measure the terminal voltage of a monitored cell or cell group using a respective voltage sensor to determine whether the voltage measurements exceed a maximum safe operating voltage limit.

Respective cell model 421 defines maximum safe operating voltage limit 506. Sensor system 410 is operable to measure repeatedly voltage of the monitored cells using the voltage sensor. For example, sensor system 410 may measure voltage with a frequency of at least 10Hz. FDS 420 is operable to compare the obtained measurements to safe operating voltage limit 506 using cell model 421 to determine whether to detect a fault.

Figure 5A illustrates plots 507 and 508 of the cell terminal voltage over time for two cell groups relative to maximum safe voltage 506 defined for the two cell groups, for example, based on the respective manufacturing specification or during initial testing of cells in the two cell groups. Plot 507 depicts a scenario where the cell terminal voltage of the respective cell group gradually rose above maximum safe operating voltage 506 and continues to rise. Plot 508 depicts a scenario where the cell terminal voltage of the respective cell group experienced a spike that exceeded maximum safe operating voltage 506 and then returned within the safe operating area. Each plot indicates that a fault occurred at the corresponding cell group and would so be interpreted by respective cell model 421 defining maximum safe voltage 506.

Since the voltage at each cell group exceeded maximum safe operating voltage 506, the cells in the cell groups may have been damaged and have the potential to catch fire. Therefore, where FDS 420 or CMD 400 is operable to determine severity levels of detected faults, FDS 420 or CMD 400 may classify the detected fault for both cell groups as having the severity level of an immediate hazard fault. Table 1 provides illustrative examples of maximum safe voltage limits for particular types of lithium-ion cells.

**Table 1**

| **Cell** | **Maximum Voltage** |
|---|---|
| Cell A: 72 Ah Prismatic LiFePO4 | 3.65 V |
| Cell B: 20 Ah Pouch LiFePO4 | 3.6 V |
| Cell C: 3.3 Ah 18650 cylindrical NMC (nickel manganese cobalt oxide) | 4.2 V |
| Cell D: 23 Ah LTO (lithium-titanate-oxide) Prismatic | 2.7 V |

Although the example scenarios of Figure 5A are described with reference to a maximum safe operating voltage limit, CMD 400 may use a similar cell model to ensure that a fault is detected when the cell terminal voltage exceeds a maximum normal operating limit. If a cell terminal voltage measurement or a sequence of such measurements exceeds the maximum normal operating limit but is within the maximum safe operating limit, then CMD 400 may classify the detected fault as having the severity level of a degradation hazard fault.

### Cell Over Temperature Fault

With reference to Figure 5B, when the temperature of a cell exceeds a maximum safe temperature specified by the manufacturing specification of the cell, the cell may be damaged and has the potential to catch fire. Therefore, in some embodiments, CMD 400 is configured to repeatedly measure the temperature of a monitored cell group using respective one or more temperature sensors to determine whether the temperature exceeds the maximum safe operating temperature limit.

Respective cell model 421 defines safe operating temperature limit 511. Sensor system 410 is operable to obtain temperature measurements at or of the monitored cells using the temperature sensor(s), for example, with a frequency of at least once per second. FDS 420 is operable to compare the obtained measurements to safe operating temperature limit 511 using cell model 421 to determine whether to detect a fault.

Figure 5B illustrates plots 512 and 513 of the cell temperature over time for two cell groups relative to maximum safe operating temperature 511 defined for the cells in the two cell groups, for example, based on a respective manufacturing specification of the cells or during initial testing of the cells. Plot 512 depicts that the temperature of the respective cell group gradually rose above maximum safe operating temperature 511 and continues to rise. Plot 513 depicts that the temperature of the respective cell group experienced a spike that exceeded maximum safe operating temperature 511 and then returned within the SOA. Each plot indicates that a fault occurred at the respective cell group.

Since the temperature of each cell group exceeded maximum safe operating temperature 511, the cells likely to have been damaged and have the potential to catch fire. Therefore, the detected fault for both cell groups may be classified as having the severity level of an immediate hazard fault.

Table 2 provides illustrative examples of maximum safe temperature limits for particular types of lithium-ion cells.

**Table 2**

| **Cell** | **Maximum Temperature** |
|---|---|
| Cell A: 72 Ah Prismatic LiFePO4 | 50 Centigrade |
| Cell B: 20 Ah Pouch LiFePO4 | 60 Centigrade |
| Cell C: 3.3 Ah 18650 cylindrical NMC | 60 Centigrade |
| Cell D: 23 Ah LTO Prismatic | 55 Centigrade |

Although the example shown in Figure 5B is described with reference to a maximum safe operating temperature limit, CMD 400 may use a similar cell model to ensure that a fault is detected when the operating temperature of the cell exceeds a maximum normal operating limit. If a temperature measurement or a sequence of such measurements exceeds the normal operating limit but is within the safe operating limit, the detected fault may be classified as having the severity level of a degradation hazard fault.

### Cell Over Current Fault

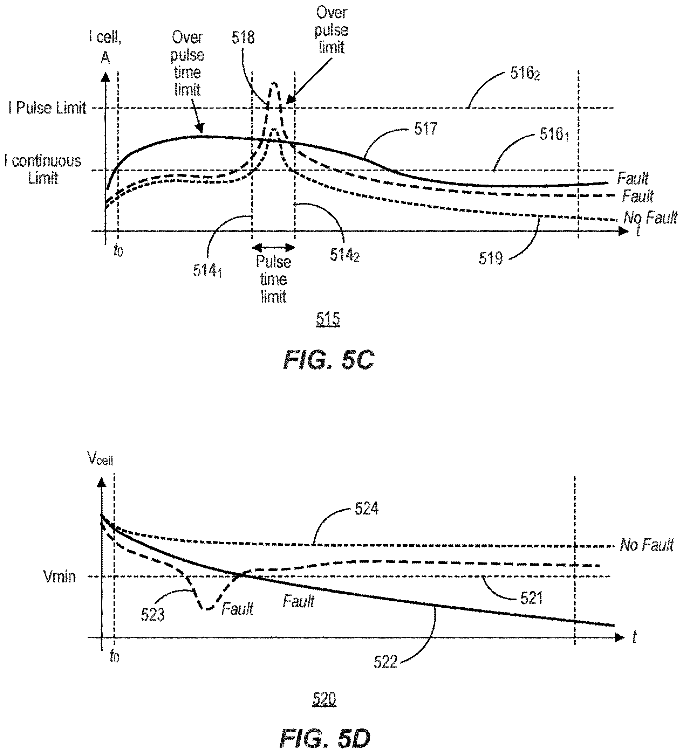

With reference to Figure 5C, when the current flowing through a cell exceeds a maximum safe current specified by the manufacturing specification of the cell, the cell may be damaged and has the potential to catch fire. Therefore, in some embodiments, CMD 400 is configured to repeatedly measure the current flowing through (in and out) a monitored cell group (one or more cells) using a respective current sensor to determine whether the current exceeds the maximum safe operating current limit.

Respective cell model 421 defines safe operating current limits 514 and 516. Sensor system 410 is operable to obtain measurements of the monitored cells using the current sensor with a frequency of every 10 mS. FDS 420 is operable to compare the obtained measurements with safe operating limits 514 and 516 using cell model 421 to determine whether a cell experienced a fault.

Figure 5C illustrates plots 517, 518, and 519 of the current over time for three cell groups relative to plots 514₁, 514₂, 516₁, and 516₂ that define safe operating current limits for the three cell groups. Plots 514i and 514₂ define the maximum safe duration of a pulse, i.e., safe time pulse limit. Plot 516i defines the maximum safe limit for a continuous current flowing through the cell, while plot 516₂ defines the maximum safe limit for a pulse current.

Plot 517 depicts that the current flowing through a respective cell group exceeded maximum safe continuous current limit 516i for a period of time longer than safe time pulse limit 514₁ to 514₂. Thus, although the current represented by plot 517 did not exceed maximum safe current pulse limit 516₂, plot 517 indicates that a fault arose at the respective cell group.

Plot 518 depicts that the current flowing through a respective cell group experienced a pulse. Although duration of the pulse depicted by plot 518 was within safe time pulse limits 514₁ to 514₂, the current value of the pulse exceeded maximum safe current pulse limit 516₂. Thus, plot 518 also indicates that a fault arose at the respective cell group.

Similar to plot 518, plot 519 depicts that the current flowing through a respective cell group experienced a pulse. However, unlike the spiked pulse of plot 518 and excessively long pulse of plot 517, the pulse of plot 519 did not exceed safe time pulse limit 514₁ to 514₂, maximum safe continuous current limit 516₁, or maximum safe current pulse limit 516₂. Thus, plot 519 does not indicate a fault.

Since the current depicted by plots 517 and 518 exceeded at least one safe operating limit, the respective cells likely to have been damaged and have the potential to catch fire without delay. Therefore, the detected faults may be classified as having the severity level of an immediate hazard fault.

Table 3 provides illustrative examples of safe operating current limits for particular types of cells.

**Table 3**

| **Cell** | **Maximum current** |
|---|---|
| Cell A: 72 Ah Prismatic LiFePO4 | 72 A continuous charging |
| | 144 A continuous discharging |
| | 576 A for 10 seconds pulse discharge |
| | 288 A for 30 seconds pulse discharge |
| Cell B: 20 Ah Pouch LiFePO4 for 50% State of Charge (SoC) and 30 degrees C. | 60 A continuous charging |
| | 200 A for 10 seconds pulse charge |
| | 200 A continuous discharging |
| | 600 A for 10 seconds pulse discharge |
| Cell C: 3.3 Ah 18650 cylindrical NMC | 2.1 A continuous charging |
| | 10 A continuous discharge |
| Cell D: 23 Ah LTO Prismatic | 100 A continuous charging |
| | 200 A for 10 seconds pulse charge |
| | 100 A continuous discharging |
| | 200 A for 10 seconds pulse discharge |

Although the example shown in Figure 5C is described with reference to safe operating current limits, CMD 400 may use a similar cell model to ensure that a fault is determined when the current flowing through cells exceeds a normal operating current limit. If a current measurement or a sequence of such current measurements exceeds at least one of the normal operating limits but is within the respective safe operating limit, the detected fault may be classified as having the severity level of a degradation hazard fault.

The pulse time limit approach described with reference to Figure 5C for current measurements can be also used to evaluate other types of measurements obtained at the monitored cells, such as voltage and temperature. Different types of measurements may have different pulse time limits for determining whether a cell experienced a fault. For example, a pulse time limit of a substantially shorter duration (e.g., 1 second) than for current measurements (e.g., 10 second) could be used to evaluate voltage measurements. The voltage pulse may be caused by an impulse of energy returned from a load or by an external electrical noise. A filter, as described with reference to other measurements, such as with reference to Figures 5A to 5N, may be applied before a fault is determined.

### Cell Under Voltage Fault

With reference to Figure 5D, when the terminal voltage of a cell is below a minimum safe voltage specified by the manufacturing specification of the cell, the cell may be damaged, and that damage may cause a delayed hazard. For example, over discharge can cause lithium plating, leading to dendrite growth and possible thermal runaway if a cell is subsequently charged at a later time. Therefore, in some embodiments, CMD 400 is configured to repeatedly measure the terminal voltage of a monitored cell group using a respective voltage sensor to determine whether the voltage measurements fall below the minimum safe operating voltage limit.

Respective cell model 421 defines minimum safe operating voltage limit 521. Sensor system 410 is operable to obtain voltage measurements of monitored cells using the voltage sensor with a frequency of at least every 100 mS. FDS 420 is operable to compare the obtained measurements to minimum safe operating voltage limit 521 using cell model 421 to determine whether a cell experienced a fault.

Figure 5D illustrates plots 522, 523, and 534 of the cell terminal voltage over time for three cell groups relative to minimum safe voltage 521 defined for the three cell groups, for example, based on the respective manufacturing specification or during initial testing of cells in the two cell groups. Plot 522 depicts a scenario where the cell terminal voltage of the respective cell group gradually falls below minimum safe operating voltage 521 and continues to fall. Plot 523 depicts a scenario where the cell terminal voltage of the respective cell group experienced a negative spike that fell below minimum safe operating voltage 521 and then returned within the safe operating area.

Both plots 522 and 523 indicate that a corresponding cell group experienced a fault and would be so interpreted by respective cell model 421. Since the voltage at each cell group fell below minimum safe operating voltage 521, the cells in the cell groups likely to have been damaged, and that damage may cause a delayed hazard. Therefore, CMD 400 may classify the determined fault for both cell groups as having the severity level of a delayed hazard fault where FDS 420 is operable to determine severity levels of determined faults.

Plot 524 depicts a scenario where the cell terminal voltage of the respective cell never falls below minimum safe operating voltage limit 521, and cell model 421 will not detect any fault in relation to plot 524.

Table 4 provides illustrative examples of maximum safe voltage limits for particular types of lithium-ion cells.

**Table 4**

| **Cell** | **Maximum Voltage** |
|---|---|
| Cell A: 72 Ah Prismatic LiFePO4 | 2.5 V |
| Cell B:20 Ah Pouch LiFePO4 | 2.0 V |
| Cell C: 3.3 Ah18650 cylindrical NMC | 2.75 V |
| Cell D: 23 Ah LTO Prismatic | 1.5 V |

Although the example scenarios of Figure 5D are described with reference to a safe operating voltage limit, CMD 400 may use a similar cell model to ensure that a fault is determined when the cell terminal voltage falls below a minimum normal operating limit.

### Cell Under Temperature Fault

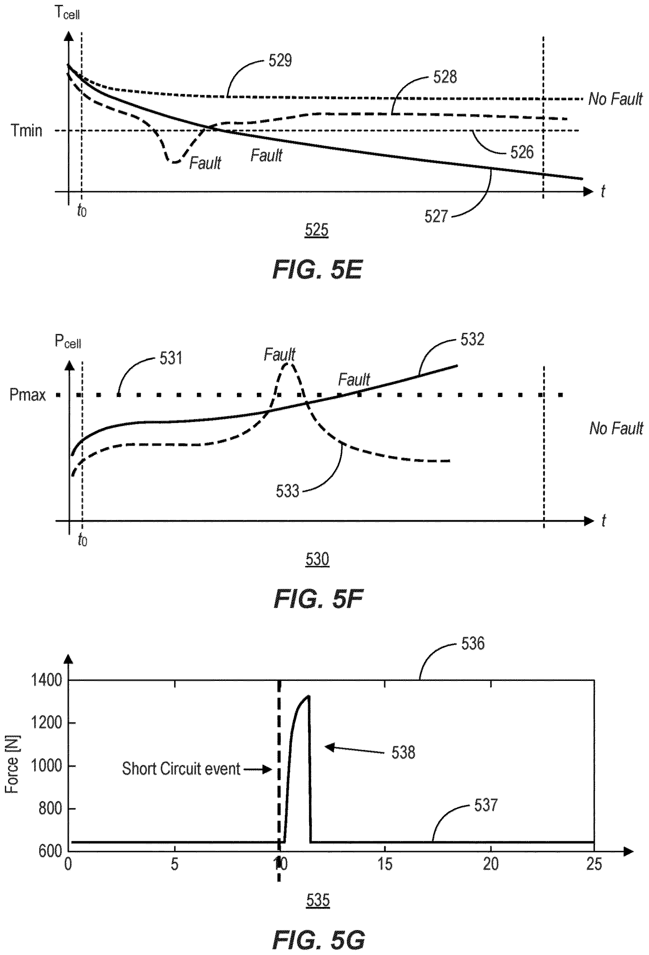

With reference to Figure 5E, when the temperature of a cell falls below a minimum safe temperature specified by the manufacturing specification of the cell, the cell may be damaged, and that damage may cause a delayed hazard. For example, low temperature charging can cause lithium plating, and subsequent dendrite growth, eventually leading to piercing of the cell separator and a localised short circuit. As another example, the electrolyte within a cell may start crystalising if the cell is stored below a certain minimum storage temperature. Therefore, in some embodiments, CMD 400 is configured to repeatedly measure the temperature at or of a monitored group of one or more cells using a respective temperature sensor to determine whether the temperature falls below the minimum safe operating temperature limit.

Respective cell model 421 defines minimum safe operating temperature limit 526. Sensor system 410 is operable to obtain temperature measurements at or of the monitored cells using the temperature sensor(s), for example, with a frequency of at least once per second. FDS 420 is operable to compare the obtained measurements to minimum safe operating temperature limit 526 using cell model 421 to determine whether to detect a fault.

Cell model 421 may employ different minimum safe operating temperature limits depending on whether a cell group is charging, discharging, or being stored when temperature measurements at or of the cell group are obtained.

Figure 5E illustrates plots 527, 529, and 529 of the cell temperature over time for three cell groups relative to minimum safe operating temperature 526 defined for the cells in the three cell groups, for example, based on a respective manufacturing specification of the cells or during initial testing of the cells. Plot 527 depicts that the temperature of the respective cell group has gradually fell below minimum safe operating temperature 526 and continues to fall. Plot 528 depicts that the temperature of the respective cell group experienced a negative spike that fell below minimum safe operating temperature 526 and then returned within the SOA.

Both plots 527 and 528 indicate that a fault occurred at the respective cell group. Since the temperature of each cell group fell below minimum safe operating temperature 526, the cells likely to have been damaged, and that damage may cause a delayed hazard. Therefore, the detected fault for both cell groups may be classified as having the severity level of a delayed hazard fault.

Plot 529 depicts a scenario where the temperature of the respective cell never falls below minimum safe operating temperature limit 526, and cell model 421 will not determine any fault in relation to plot 529.

Table 5 provides illustrative examples of minimum safe temperature limits for particular types of lithium-ion cells.

**Table 5**

| **Cell** | **Maximum Temperature** |
|---|---|
| Cell A: 72 Ah Prismatic LiFePO4 | 0 Centigrade when charging |
| | -20 Centigrade when discharging |
| Cell B:20Ah Pouch LiFePO4 | -40 Centigrade when stored |
| | -20 Centigrade when charging/discharging |
| Cell C: 3.3 Ah 18650 cylindrical NMC | 0 Centigrade when charging |
| | -20 Centigrade when discharging |
| Cell D: 23 Ah LTO Prismatic | -40 Centigrade when stored |
| | -30 Centigrade when charging/discharging |

Although the example shown in Figure 5E is described with reference to a minimum safe operating temperature limit, CMD 400 may use a similar cell model to ensure that a fault is detected when the operating temperature of the cell falls below a normal operating temperature limit.

### Cell Over Pressure Fault

With reference to Figure 5F, when the internal pressure of a cell exceeds a maximum safe pressure defined by the manufacturing specification of the cell, the cell is likely damaged and has the potential to catch fire, vent, or explode. Therefore, in some embodiments, CMD 400 is configured to repeatedly measure the pressure of one or more monitored cells using a respective pressure sensor (e.g., gas pressure sensor, strain gauge, etc.) to determine whether the internal pressure of each monitored cell exceeds the maximum safe operating pressure limit.

Respective cell model 421 defines maximum safe operating pressure limit 531. Sensor system 410 is operable to obtain pressure measurements of monitored cells using a pressure sensor, for example, with a frequency of 1 Hz. Sensor system 410 may measure the internal pressure of a cell directly, for example, using a gas pressure sensor integrated within the cell enclosure, or indirectly, using a sensor that measures the effects of pressure. Examples of sensors that allow measuring the effects of internal cell pressure include, but are not limited to, a force sensor configured to measure the force exerted by the cell onto an external surface caused by a change of internal pressure, and a strain gauge configured to monitor the deflection of the cell enclosure caused by a change of internal pressure.

FDS 420 is operable to compare pressure measurements to maximum safe operating pressure limit 531 using cell model 421 to determine whether to detect a fault. If sensor system 410 measures the internal cell pressure by its effects, then maximum safe operating pressure limit 531 represents a maximum safe operating limit for the measured effect, e.g., maximum safe operating force or maximum safe operating deflection.

Cell pressure is directly proportional to temperature. Therefore, maximum safe operating pressure limit varies as the temperature of a cell raises or lowers. In some embodiments, cell model 421 compensates the obtained pressure measurements or maximum safe operating pressure limit 531, or both, for the temperature conditions present when sensor system 410 obtained respective pressure measurements, before comparing the obtained pressure measurements to maximum safe operating pressure limit 531. For example, cell model 421 may receive both pressure and temperature measurements contemporaneously as input from respective sensors. By compensating pressure measurements or maximum safe operating pressure limit 531 for temperature condition, FDS 420 can assess more accurately whether the obtained pressure measurements indicate a fault, than if no temperature compensation is performed.

Figure 5F illustrates plots 532 and 533 of cell internal pressure over time for two cells relative to maximum safe operating pressure 531 defined for the cells, for example, based on a respective manufacturing specification of the cells or during initial testing of the cells. Plot 532 depicts that the internal pressure of the respective cells gradually rose above maximum safe operating pressure 531 and continues to rise. Plot 533 depicts that the internal pressure of the respective cell experienced a spike that exceeded maximum safe operating pressure 531 and then returned within the SOA. Each plot indicates that a fault occurred at the respective cell group.

Since the internal pressure of each cell exceeded maximum safe operating pressure 531, the cells likely to have been damaged and have the potential to catch fire, vent, or explode. Therefore, the detected fault for both cell groups may be classified as having the severity level of an immediate hazard fault.

As an example, cell model 421 would deem that a cell is experiencing a fault if its internal pressure exceeds 100 kPa at 25 degrees centigrade. A maximum safe operating pressure limit (over-pressure threshold) may vary for different cells and different cell manufacturers.

Although the example shown in Figure 5F is described with reference to a maximum safe operating pressure limit, CMD 400 may use a similar cell model to detect a fault when the operating pressure of the cell exceeds a maximum normal operating limit. If a pressure measurement or a sequence of such pressure measurements exceeds the normal operating limit but is within the safe operating limit, the detected fault may be classified as having the severity level of a degradation hazard fault.

The internal cell pressure spiking for a short time period and subsequently returning to a lower pressure can indicate a delayed hazard at a respective cell (such as sudden evolution of gas due to a localised short circuit or dendrite growth), even if the internal pressure during the spike remains within bounds of SOA or NOA. Therefore, in some embodiments, respective cell model analyses internal pressure measurements of a cell for rapid increases and decreases. This scenario is shown in Figure 5G.

Figure 5G illustrates plot 537 of the force exerted by a cell onto an external surface due to changes in the internal pressure over time. Plot 536 reflects that the internal pressure of the monitored cell raised and lowered rapidly, forming spike 538. In example of Figure 5G, spike 538 was caused by a short circuit event experienced by the cell. Although spike 538 at its peak is below maximum safe operating limit 536, it reflects an event that is likely to cause a delayed hazard at the cell (such as weakening of the cell in the area of the short circuit event), and thus is detected as a fault using respective cell model 421.

### BEHAVIOURAL FAULT EXAMPLES

In some embodiments, when a cell or cell group is behaving not as expected, a CMD, such as CMD 400, is operable to detect a corresponding behavioural fault. Respective cell model 421 defines expected behaviour of the cell or cell group. For example, cell model 421 may define expected values or range of values for measured properties of the cell or cell group responsive to a given stimulus. When behaviour of a monitored cell or cell group deviates from the cell behaviour defined by a respective cell model 421, FDS 420 detects a fault, even if measurements obtained at the monitored cell or cell group fall within safe operating limits and normal operating limits.

One or more thresholds may be used to determine whether behaviour of the monitored cell or cell group deviates from the modelled behaviour. Different thresholds may be used for different cell properties, different cell states, different conditions, etc.

Additionally or alternatively, in some embodiments, CMD 400 is operable to compare measurements obtained at different cells to identify faults. For example, CMD 400 may compare measurements that sensor system 410 obtains at cells within the same cell group monitored by CMD 400, using independent sensors (e.g., gas pressure sensors). Anomalies or deviations in measurements exhibited by one cell in the cell group when compared to measurements obtained at the other cells in the cell group can indicate a behavioural fault, even if the deviating measurements fall within respective safe operating limits or normal operating limits.

Additionally or alternatively, CMD 400 may compare measurements obtained at a monitored cell or cell group with corresponding measurements obtained at neighbouring cells that are not monitored by CMD 400. Anomalies or deviations in measurements exhibited by a monitored cell or the cell group when compared to measurements obtained at the neighbouring cells can indicate a behavioural fault at the monitored cell or cell group, even if the measurements obtained at the monitored cell or cell group fall within respective safe operating limits or normal operating limits. CMD 400 may be operable to receive measurements of neighbouring cells directly from CMD(s) monitoring the neighbouring cells or through BMS 430.

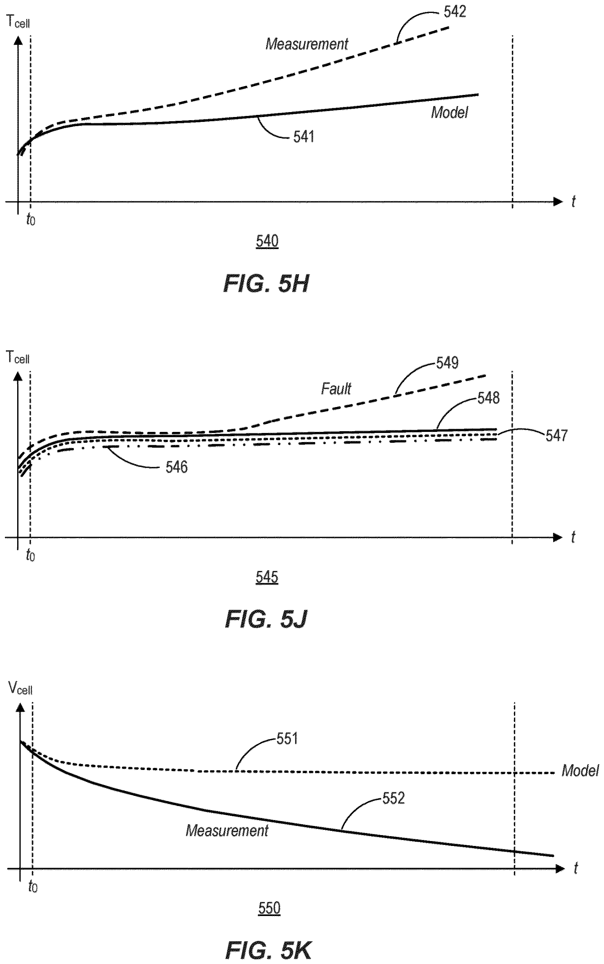

Figures 5H to 5N illustrate examples of behavioural faults that could be detected by a CMD according to the present disclosure, such as CMD 400.

### Unexpected Cell Temperature Change

Variations between the rate of change of temperature measured at a monitored cell or cell group and a rate of change of temperature predicted by a thermo-electrical model of the cell or cell group for a known stimulus (e.g., voltage, current, or both) and the state of the cell or cell group (e.g., a state of charge, a SoH, or internal resistance) can be indicative of a behavioural fault at the monitored cell or cell group. In some embodiments, cell model 421 defines a thermo-electrical model of expected temperature changes for the monitored cell or cell group responsive to predefined stimuli in preset cell states, and a deviation threshold. When the rate of change of temperature of the monitored cell or cell group deviates from a rate of change predicted by the thermo-electrical model by more than the predefined deviation threshold, FDS 420 of CMD 400 is operable to detect a fault. For example, if cell model 421 predicts that a 1A current should lead to rise of temperature from 25 to 30 degrees after 1 minute, while corresponding measurements obtained at the monitored cell or cell group reflect the same rise in 30 seconds, then FDS 420 of CMD 400 would detect a behavioural fault.

Figure 5H illustrates a similar scenario. In Figure 5H, plot 542 depicts changes in temperature measured at a monitored cell or cell group, while plot 541 depicts modelled changes in temperature for the same stimulus and state of the cell or cell group according to a thermo-electrical model defined by cell model 421. Plots 542 and 541 respectively indicate that the measured temperature rises substantially faster than the predicted temperature, which in turn indicates a behavioural fault at the monitored cell or cell group.

### Differential Temperature Change

Variations in behaviour between the same type of cells being exposed to the same stimulus can indicate that a fault arose at one or more such cells. For example, a rate of change of temperature measured at one cell or cell group being different from a rate of change of temperature measured at other cells or cell groups for the same stimulus (e.g., voltage and current) and considering the state of the respective cells or cell groups (e.g., a state of charge, a SoH, or internal resistance) can indicate a behavioural fault at the cell or cell group whose rate of change deviates from the others.

In some embodiments, cell model 421 defines one or more deviation thresholds for use when comparing measurements of different cells or cell groups. For example, different deviation thresholds may be set for different stimuli, cell states, or both.

When FDS 420 determines that a rate of change of temperature of a monitored cell or cell group deviates from a rate of change of neighbouring cells or cell group by more than a corresponding deviation threshold of model 421, FDS 420 detects a behavioural fault. For example, if FDS 420 determines that all cells in a battery system remain at a constant 30 C, except for a cell or cell group that CMD 400 monitors and that cell or cell group's temperature rises to 40 C, FDS 420 determines a behavioural fault.

Figure 5J illustrates a similar scenario, where four different cells are exposed to the same stimulus. Plots 546, 547, and 548 depict consistent changes in temperature measured at three of four such cells. Plot 549 depicts changes in temperature that deviate significantly, i.e., by more than a predefined deviation threshold, from changes in temperatures depicted by plots 546, 547, and 548. In particular, plot 549 shows that the temperature of the corresponding cell rises substantially faster than the temperature of the other three cells corresponding to plots 546, 547, 548. Thus, CMD 400 will detect a behavioural fault at the cell corresponding to plot 549.

### Unexpected Voltage Change

Variations between the rate of change of voltage measured at a monitored cell or cell group and a rate of change of voltage predicted by a thermo-electrical model of the cell or cell group for a known stimulus (e.g., temperature, current, or both) and the state of the cell or cell group (e.g., a state of charge, a SoH, or internal resistance) can be indicative of a behavioural fault arisen at the cell or cell group. In some embodiments, cell model 421 defines a thermo-electrical model of expected voltage changes for the monitored cell or cell group responsive to predefined stimuli in preset states, and a deviation threshold. When the rate of change of voltage of the monitored cell or cell group deviates from a rate of change predicted by thermo-electrical model by more than the predefined deviation threshold, FDS 420 of CMD 400 is operable to detect a fault. For example, if cell model 421 predicts that with zero current and stable temperature, the voltage should drop by no more 50 mV in an hour, while corresponding measurements obtained at the monitored cell or cell group reflect the same drop in 10 minutes, then FDS 420 of CMD 400 would detect a behavioural fault.

Figure 5K illustrates a similar scenario. In Figure 5K, plot 552 depicts changes in voltage measured at a monitored cell or cell group, while plot 551 depicts modelled changes in voltage for the same stimulus and state of the cell or cell group according to a thermo-electrical model defined by cell model 421. Plots 552 and 551 indicate that the measured voltage falls substantially faster than the predicted voltage respectively, which in turn indicates a behavioural fault at the monitored cell or cell group.

### Differential Voltage Change

Variations in behaviour between the same type of cells being exposed to the same stimulus can indicate that a fault arose at one or more such cells. For example, a rate of change of voltage measured at one cell or cell group being different from a rate of change of voltage measured at other cells or cell groups for the same stimulus (e.g., current, temperature, or both) and considering the state of the respective cells or cell groups (e.g., a state of charge, a SoH, or internal resistance) can indicate a behavioural fault at the cell or cell group whose rate of change deviates from the others.

In some embodiments, cell model 421 defines one or more deviation thresholds for use when comparing measurements of different cells or cell groups. Different deviation thresholds may be set for different stimuli, cell states, or both. A difference between measurements of compared cells exceeding a respective deviation threshold indicates a behavioural fault.

When FDS 420 determines that a rate of change of voltage of a monitored cell or cell group deviates from a rate of change of neighbouring cells or cell group by more than a corresponding deviation threshold of model 421, FDS 420 detects a behavioural fault. For example, if FDS 420 determines that all cells in a battery system remain at a constant 3.7 V ±50 mV, except for a cell or cell group that CMD 400 monitors, and that cell or cell group's voltage drops to 3.5 V, FDS 420 determines a behavioural fault.

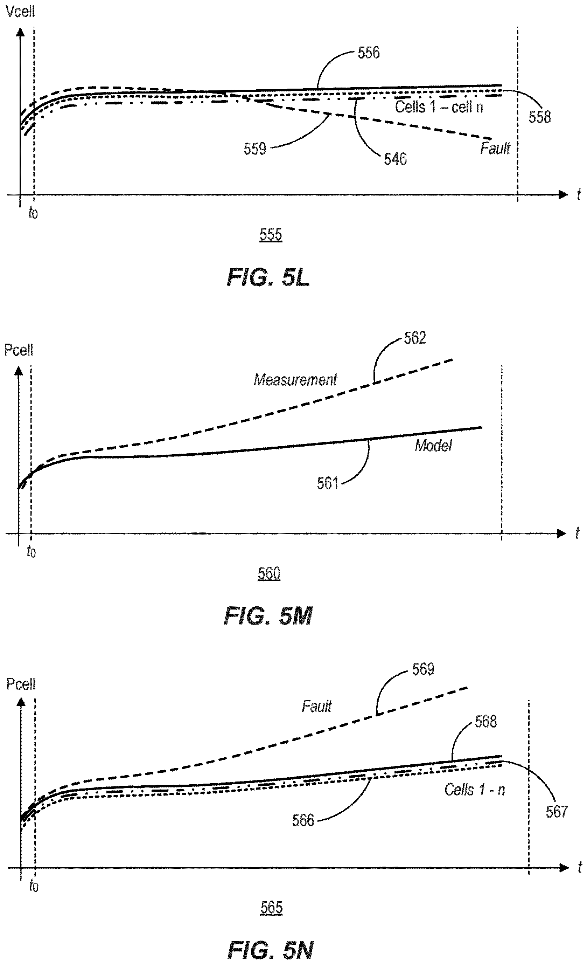

Figure 5L illustrates a similar scenario, where four different cells are exposed to the same stimulus. Plots 556, 557, and 558 depict consistent changes in voltage measured at three of four such cells. Plot 559 depicts changes in voltage that deviate significantly, i.e., by more than a predefined deviation threshold, from changes in voltage depicted by plots 556, 557, and 558. In particular, plot 559 shows that the voltage of the corresponding cell fell while the voltage depicted by plots 556, 557, and 558 slowly rises. Thus, CMD 400 detects a behavioural fault at the cell corresponding to plot 559.

In some embodiments, divergence in cell voltages between different cells is evaluated in relation to a time period over which the divergence has occurred. A gradual divergence in cell voltages between different cells is expected over long periods of time (such as days to months), and thus is not necessarily indicative of a fault. Thus, the same level of divergence may indicate a behavioural fault when detected over minutes or hours, but not indicate a behavioural fault when detected over days or months. The deviation threshold therefore may be adjusted depending on the time period over which the divergence is detected. For example, the deviation threshold may increase as the time period over which the divergence between the cells is detected increases.

### Unexpected Pressure Change

Variations between the rate of change of internal pressure of a monitored cell and a rate of change of internal pressure predicted by a model of the cell for a known stimulus (e.g., voltage, temperature, current, or a combination thereof) and the state of the cell or cell group (e.g., a state of charge, a SoH, or internal resistance) can be indicative of a behavioural fault at the cell. In some embodiments, cell model 421 defines modelled internal pressure changes for the monitored cell responsive to predefined stimuli in preset states, and a deviation threshold. When the rate of change of internal pressure of the monitored cell deviates from a rate of change predicted by respective model 421 by more than the predefined deviation threshold, FDS 420 detects a fault.

In some embodiments, cell model 421 defines one or more thresholds for predefined stimuli and preset state. When FDS 420 determines that the rate of change of internal pressure of the monitored cell exceeds a corresponding threshold, FDS 420 detects a fault. For example, cell model 421 may set a maximum rate of change of pressure threshold of +/-0.1 kPa/s. If FDS 420 determines, based on respective measurements at the monitored cell, that the rate of change of pressure is greater than the preset threshold, FDS 420 detects a behavioural fault.

The internal pressure of a cell is expected to increase over the cell life, where the pressure is proportional to that cell's SoH. In some embodiments, cell model 421 sets out the relationship between cell pressure and SoH. If FDS 420 determines, based on respective measurements at the monitored cell, that cell pressure increased more than expected, FDS 420 detects a behavioural fault. If FDS 420 determines, based respective measurements at the monitored cell, that cell pressure decreases when the pressure is expected to increase over time a cell, FDS 420 detects a behavioural fault. Such a decrease is indicative of the cell having a leak.

Figure 5M illustrates one such a scenario. In Figure 5M, plot 562 depicts changes in internal pressure of a cell determined based on respective measurements obtained at the cell. Plot 546 depicts modelled changes in internal pressure of the same cell according to cell model 421. Plots 562 and 561 indicate that the measured cell pressure raised substantially faster than the modelled cell pressure, which in turn indicates a behavioural fault at the monitored cell.

### Differential Pressure Change

Variations in behaviour between the same type of cells being exposed to the same stimulus can indicate a fault at one or more such cells. For example, an internal pressure of one cell in a battery pack being different from an internal pressure of other cells in the same pack for the same stimulus (e.g., voltage, temperature, current, or combination thereof) and considering the state of the respective cells (e.g., a state of charge, a SoH, or internal resistance) can indicate a behavioural fault at the cell whose internal pressure deviates from the others.

In some embodiments, cell model 421 defines one or more deviation thresholds for use when comparing measurements of different cells or cell groups. For example, different deviation thresholds may be set for different stimuli, cell states, or both.

When FDS 420 determines that an internal pressure of a monitored cell deviates from an internal pressure of neighbouring cells by more than a corresponding deviation threshold of model 421, FDS 420 detects a behavioural fault. For example, if FDS 420 determines that all cells in a battery system or pack are at cell pressure of 50 kPa, except for a cell that CMD 400 monitors, and that cell's pressure is above or below of that of the other cells by a given percentage, or more than a given percentage (e.g., a deviation threshold of 5%), FDS 420 determines a behavioural fault.

Figure 5N illustrates a similar scenario, where four different cells are exposed to the same stimulus. Plots 566, 567, and 568 depict consistent changes in internal pressure of three of four such cells. Plot 569 depicts changes in internal pressure of a respective cell that deviate significantly, i.e., by more than a predefined deviation threshold, from changes in cell pressure depicted by plots 566, 567, and 568. In particular, plot 569 shows that the internal pressure of the corresponding cell rises substantially faster than the internal pressure of other three cells corresponding to plots 566, 567, 568, which rises slowly and consistently among the respective three cells Thus, CMD 400 will detect a behavioural fault at the cell corresponding to plot 569.

In some embodiments, the frequencies with which sensor system 410 measures various cell properties discussed with reference to Figures 5A to 5N are configurable. For the example, the frequency with which a particular cell property is measured can be adjusted responsive to measurements of the same or other cell properties obtained at the monitored cells (e.g., voltage, current, temperature, pressure, etc.), a detected state of the monitored cells, measurement trends exhibited by the monitored cells, a state of health of the monitored cells, intended use of the monitored cells, etc. For the example, the frequency may be decreased when one, some, or all such parameters indicate that the respective cells operate safely within their NOA, and increased when one, some, or all such parameters indicate that the cells operate at or close to the boundaries set by their NOA or SOA. In the context of behavioural faults, the frequency with which cell properties are measured may be increased as the difference between measurements of different cells or cell groups or with a predefined behaviour approaches a respective deviation threshold.

In some embodiments, one more cell models 421, such as cell models described with reference to Figures 5A to 5N, may apply a filter to the obtained measurements to reduce false fault detection before determining a fault. For example, the filter may require that a predefined number of sequential measurements (e.g., 3 or more, 4 or more, 5 or more, etc.) or a predefined number in a sequential sample (e.g., 3 out of 4, 4 out of 5, 4 out of 6, 5 out 6, etc.) exceeds, below, or falls outside relevant limits or thresholds defined by the respective cell model or deviate from expected behaviour as defined by the cell model, deviate from measurements obtained at other cells.

Multiple example scenarios have been described with reference to Figures 5A to 5N. Where such scenarios reference a cell group, the cell group can consist of a single cell or of a plurality of cells, for example, a plurality of cells connected in parallel.

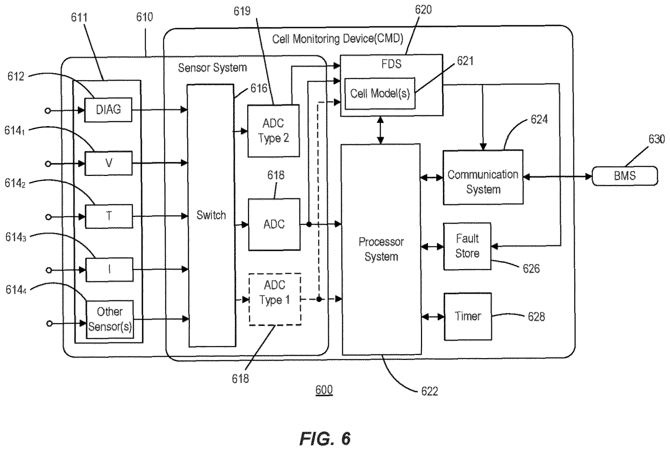

Figure 6 is a schematic illustration of an arrangement of CMD 600, according to some embodiments. CMD 600 includes similar components to components of CMD 400 described with reference to Figure 4. Therefore, description of sensor system 410, FDS 420, processor system 422, communication system 424, fault store 426, and timer or clock 428 with reference to Figures 4 to 5N respectively applies to sensor system 610, FDS 620, processor system 622, communication system 624, fault store 626, and timer or clock 628, and thus is not repeated. Rather, description of Figure 6 focuses on differences between CMD 400 and CMD 600.

In addition to the functions described with reference to Figure 4, FDS 620 and sensor system 610 of CMD 600 provide for a redundant and diverse mechanism for determining faults related to measurements obtained at cells monitored by CMD 600 (such as voltage, current, temperature, pressure, etc.). For this purpose, in addition to one or more ADC 618, similar to ADC 418, sensor system 610 includes redundant and diverse ADC 619.

ADC 619 provides extra measurements to FDS 620, which FDS 620 evaluates for functional safety related fault(s). ADC 618 and ADC 619 use different conversion techniques. In some embodiments, ADC 618 achieves a higher precision with a faster conversion rate than ADC 619 and is able to support cell voltage or other measurements of many times a second, e.g., 100Hz instead of 10Hz or slower supported by ADC 619. For example, ADC 618 may have a sigma-delta architecture with minimum of 16-bit resolution, while ADC 619 may have a successive-approximation architecture with a lower resolution than ADC 618, e.g., 12-14 bit. In this manner, ADC 619 enables FDS 620 to perform functional safety checks on ADC 618. This improves safety and reliability of CMD 600 when compared to that of CMD 400.

Additional one or more ADCs may be added to CMD 600, with the additional one or more ADCs contributing to the redundancy within CMD 600. For example, the use of additional ADC(s) could offer further enhancements of the reliability and safety by using techniques such as 2 out of 3 voting or enhanced safety in the event of single ADC failure.

Unlike CMD 400, whose processor system 422 controls data communication by FDS 420, in CMD 600, FDS 620 is able to share its data directly with communication system 624. Direct communication between FDS 620 and communication system 624 enables communication system 624 to include cell status information, such as faut indicator and fault data received from FDS 620, in addition to and independent from corresponding cell status information received from processor system 622. In this manner, CMD 600 provides for a diverse and redundant fault determination. When corresponding cell status information provided by processor system 622 and FDS 420 matches, BMS 430 is assured that the cell status information is accurate. Discrepancies between corresponding cell status information provided by processor system 422 and FDS 420 would indicate to BMS 430 that CMD 600 is experiencing a fault and remedial action may be needed.

In CMD 600, FDS 620 also has direct access to fault store 626, and thus is able to store cell status information directly in fault store 626. In some embodiments, this reduces processing load on processor system 622 by making FDS 620 solely responsible for storing its data at fault store. In some other embodiments, processor system 622 runs an additional self-diagnostic check by comparing cell status information processor system 622 receives from FDS 620 with corresponding cell status information that FDS 620 stores at fault store 626.

Although, as described, CMD 600 differs from CMD 400 in that it employs additional ADC(s), allows for direct communication between FDS 620 and communication system 624, and gives FDS 620 direct access to fault store 626, such differences may be introduced into CMD 400 individually or in any combination to enhance reliability and safety of CMD 400.

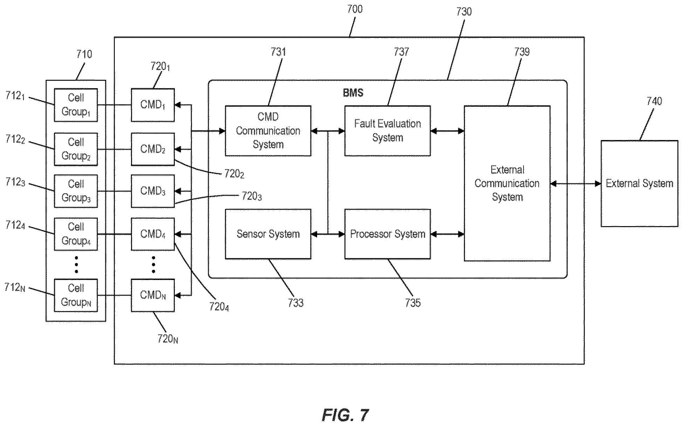

Figure 7 is a schematic illustration of an arrangement of system 700 for monitoring the state of battery system 710, according to some embodiments. Battery system 710 includes a plurality of cell groups 712i ... 712_{N}, each cell group including one or more cells. In some embodiments, each group 712ᵢ that includes more than one cell has all such cells connected in parallel.

System 700 includes a plurality CMDs 720i ... 720_{N}, such as CMD 400 or CMD 600, for respectively monitoring the cell status of cell groups (CG) 712₁ ... 712_{N}. System 700 also includes BMS 730 for monitoring and managing performance of battery system 710. System 700 includes one CMD 720 per each cell group 712. Each CMDs 720ᵢ is attached to, incorporated with, or otherwise associated with respective cell group 712i as to be able to monitor cells in cell group 712ᵢ.

To monitor and manage the performance of battery system 710, BMS 730 is operable to communicate with each of CMDs 720i ... 720_{N} to gather and process cell status information provided by CMDs 720, including fault indicators and related fault data. BMS 720 is also operable to control environment of battery system 710 and balance battery system 710.

BMS 730 includes CMD communication system 731 operable to enable communication between BMS 730 and CMDs 720, processor system 735 configured to effect operations of BMS 730 and its components, fault evaluation system 737 operable to process cell status information received from CMDs 720, including fault indicators and related fault data, and external communication system 739 operable to enable BMS 730 to communicate with various external systems and devices 740.

BMS 730 also includes sensors 733 operable to measure properties of battery system 710. In some embodiments, sensors 733 measure properties that are not necessarily measured by individual CMDs 720, such as but not limited to, a temperature sensor for measuring temperature at battery system 710 or at a battery pack included in battery system 710, a voltage sensor for measuring voltage of battery system 710 or at a battery pack included in battery system 710, a current sensor for measuring current flowing in and out of battery system 710 or at a battery pack included in battery system 710, where a battery pack includes multiple cell groups. Additionally or alternatively, sensors 733 may measure properties of individual cells and cell groups to introduce additional redundancy into system 700 to improve its overall reliability and safety.

In some embodiments, fault evaluation system 737 is operable to gather cell status information from CMDs 720 and, if such cell status information includes fault indicators, inform external system 740 that one or more faults have arisen at battery system 710 and share relevant fault data with external system 740.

External system or device 740 is operable to receive cell status information from BMS 730, including results of processing performed by BMS 730, and process the received data to identify possible remedial actions. External system 740 may be in general proximity to BMS 730, e.g., a vehicle engine control unit or another system in an electric vehicle, or be remote, e.g., an IOT server.

In some embodiments, fault evaluation system 737 analyses received cell status information to confirm faults detected by CMD 720. For example, if CMD 720 shares redundant information regarding identified faults, as for example described with reference to Figure 6, BMS 730 ensures that the redundant data regarding a particular fault matches, before confirming the fault. Additionally or alternatively, CMD 720 may perform independent analysis of received fault data using corresponding one or more cell models to confirm a respective fault identified by one or more CMDs 720.

Additionally or alternatively, fault evaluation system 737 is operable to compare cell status information received from multiple CMDs to perform one or more of: confirm faults, classify faults, identify fault source(s), or evaluate behaviour of different cell groups to identify faults. Fault evaluation system 737 may use the same techniques as described with reference to Figures 4 to 6 and CMD 400 and 600, and their FDS respectively, and is able to evaluate measurements obtained at various cell groups 712 individually or in combination. In some embodiments, fault evaluation system 737 is operable to perform BMS level fault analysis to determine faults by comparing results for a single cell group with results for other cell groups within battery 710 system experiencing the same stimulus.

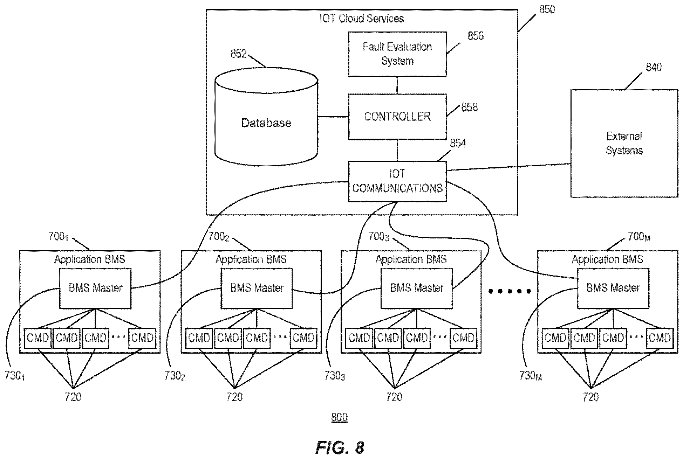

Figure 8 is a schematic illustration of an arrangement of system 800 for monitoring the state of one or more battery systems, according to some embodiments. System 800 includes a plurality of systems 700i to 700_{M} of Figure 7. Each system 700ᵢ includes corresponding BMS 730ᵢ and a plurality of CMDs 720, and monitors the status of a corresponding battery system, or a battery pack within a battery system.

System 800 also includes IOT cloud service 850 for processing faults based on information provided by BMS 730ᵢ to BMS 730_{M}. IOT cloud services 850 includes database 852 for storing fault data as well as information relevant to identification of faults, database controller 858 for controlling database 852, such as data retrieval by external systems 840, fault evaluation system 856 for evaluating fault data and analysing faults, including to identify remedial actions, and IOT communication system 854 for enabling data exchange between systems 700i to 700_{M} and IOT cloud services 850 and external systems 840 and IOT cloud services 850. IOT cloud service 850 maintains knowledge of the expected behaviour of many applications, and with that understanding is able to suggest remedial action to extend application longevity such as a change in the NOA specification. IOT cloud service 850 may employ Artificial Intelligence (AI) techniques, machine-learning techniques, or both to continuously evolve the knowledge database.

In some embodiments, system 800 monitors the status of a single battery system where each system 700ᵢ is responsible for monitoring the status of a respective battery pack in the battery system. This arrangement allows for parallel processing of property measurements and fault detection by CMDs 720 and BMS 730i, thereby providing relevant fault information to and alerting fault evaluation system 856 faster than a single system 700 could. This arrangement also enables fault evaluation system 856 to analyse and compare fault data at three different levels: based on property measurements obtained at the cell group level, based on evaluation results drawn at the CMD level (e.g., at the level of CMD 400 or 600), and based on evaluation results drawn at the BMS level (e.g., at the level of BMS 730). System 800 may apply the BMS level analysis, when information received from different systems 700 is consistent, and move to verifying the CMD level analysis or the cell group level analysis when information shared by different systems 700 differs. System 800 has knowledge of the performance of all the cells, CMDs and BMSs, and thus is able detect faults that cannot be identified by a single BMS in isolation. This allows for more efficient evaluation by fault evaluation system 856 while ensuring safety and accuracy when needed.

In some embodiments, system 800 monitors the status of multiple battery systems where each system 700ᵢ is responsible for monitoring the status of a respective battery system. Different battery systems may be located at different locations and/or perform different tasks. This arrangement allows fault evaluation system 856 to apply and share knowledge based on fault analysis performed at different battery systems. For example, if system 800 monitors the status of multiple battery systems of the same type, fault detection across all such battery systems can be improved based on experience at one or more of such battery systems. System 800 may employ machine learning or AI techniques to improve fault detection. This approach also facilitates identification of scenarios where a recall of a particular type of battery system is appropriate and implementation of the recall.

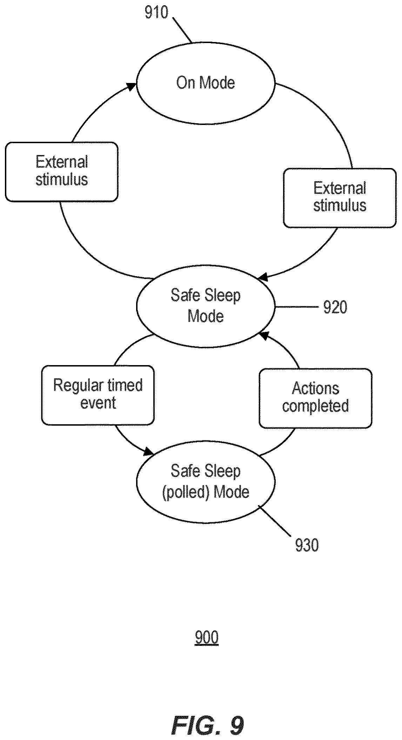

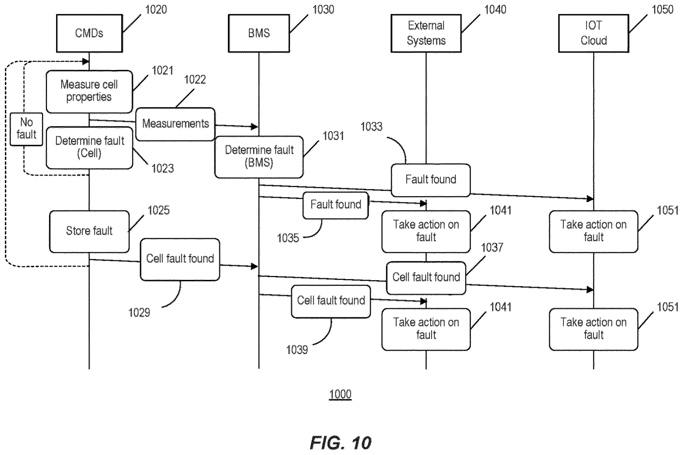

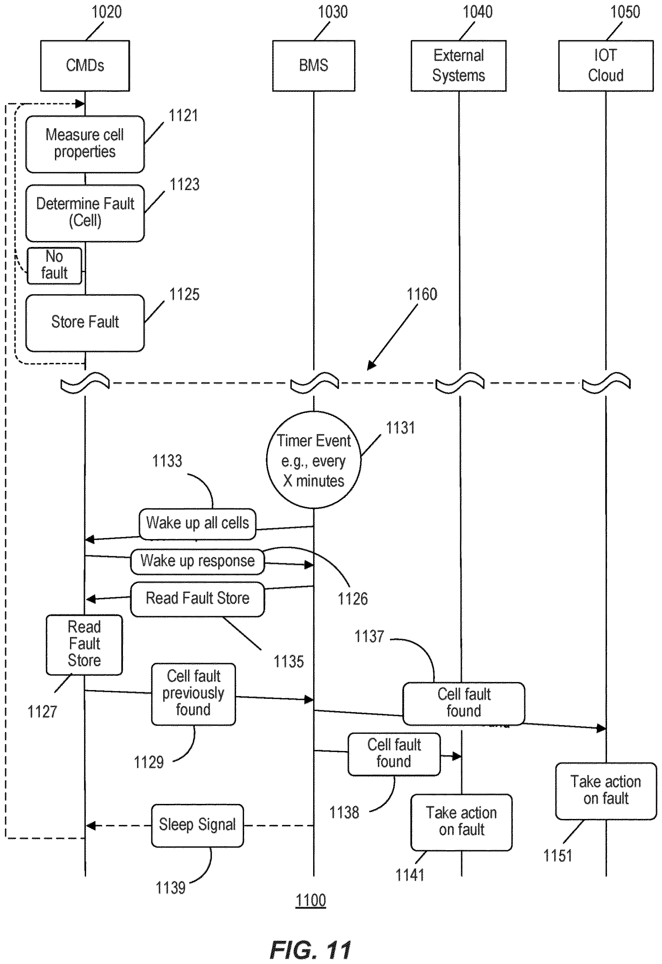

Figure 9 depicts chart 900 showing operating modes of BMS 1030 adapted for working with CMDs described in this disclosure, according to some embodiments. Descriptions of BMS 430, 630, and 730 with respect to Figures 4 to 8 is applicable to BMS 1030, while description of CMD 400, 600, and 720 with respect to Figures 4 to 8 is applicable to CMD 1020. Figures 10 and 11 show respectively process flows 1000 and 1100 in systems for monitoring the state of battery systems as described in this disclosure and including a BMS with the operating modes shown in Figure 9, according to some embodiments.

With reference to Figure 9, BMS 1030 is operable in three modes: ON mode 910 (first mode), Safe Sleep mode 920 (second mode), and Safe Sleep (polled) mode 930 (third mode).

External stimulus activates ON mode 910 at BMS 1030. For example, if a battery system monitored by BMS 1030 is used in an electric vehicle, turning the key switch or ignition on provides external stimulus that activates ON mode 910 at BMS 1030. Another external stimulus or removal of the original stimulus causes BMS 1030 to transition from ON mode 910 to Safe Sleep mode 920. In the electric vehicle example, turning the key switch or ignition off removes the original stimulus, thereby causing BMS 1030 to transition to Safe Sleep mode 920.

While in Safe Sleep mode 920, BMS 1030 is not operated and consumes only minimal power. Repeatedly, BMS 1030 wakes up and transitions from Safe Sleep mode 920 to Safe Sleep (polled) mode 930 to assess the state of the monitored battery system based on data provided by CMDs 1020. Upon completing assessment of the monitored battery system and performing related actions (e.g., reporting to an external system), BMS 1030 transitions back to Safe Sleep mode 920. BMS 1030 may wake from Safe Sleep mode 920 periodically, at regular timed intervals, e.g., every 15 minutes, random time intervals, or time intervals determined based on the state of monitored battery system. In the latter scenario, the time interval may, for example, decrease as obtained cell measurements approach the bounds of a respective SOA or NOA and increase as obtained cell measurements move further away from the SOA or NOA bounds or when cell measurements are well within the SOA or NOA bounds (e.g., as defined by respective threshold(s)).

In some embodiments, an external stimulus is used to activate first Safe Sleep mode 920 or Safe Sleep (polled) mode 930, rather than activating ON mode 910, at BMS 1030.

### ON Mode

Figure 10 illustrates process flows between CMDs 1020, BMS 1030, external systems 1040, and IOT (internet of things) cloud 1050, while BMS 1030 is operating in ON mode 910. Each CMD 1020 is an operational mode. This means that each CMD 1020 repeatedly measures cell properties (e.g., temperature and voltage) of monitored cells (step 1021), shares (e.g. transmits) the measured cell properties with BMS 1030 (step 1022), and evaluates the measured cell properties to determine faults, if any, at the monitored cells (step 1023). If CMD 1020 determines no fault at any of the monitored cells, CMD 1020 returns to measuring step 1021. If CMD 1020 determines a fault at one or more monitored cells, CMD 1020 stores locally data about the determined fault, such as a fault indicator indicating that CMD 1020 detected a fault and fault date related to the detected fault, including a timestamp identifying when CMD 1020 detected the fault and measurements based on which the fault has been detected (step 1025). CMD 1020 informs BMS 1030 about the detected fault (step 1029), for example by transmitting a respective fault indicator and related fault data. CMD 1020 then returns to measuring step 1021.

As shown in Figure 10, CMD 1020 communicates with BMS 1030 about a detected fault after storing relevant fault information locally at CMD 1020 (such as in fault store 426 described with reference to Figure 4). CMD 1020 may perform informing step 1029 immediately after storing step 1025 or with some delay. Either approach time shifts fault detection by BMS 1030 because BMS 1030 does not immediately learn about CMD 1020 determining a fault.

In some embodiments, CMD 1020 communicates with BMS 1030 about a fault immediately upon determining such a fault. In these embodiments, CMD 1020 performs informing step 1029 prior to storing step 1025, with no time shifting.

At step 1031, BMS 1030 processes the measurements received from each CMD 1020 for faults independent of the analysis performed by respective CMD 1020. Additionally or alternatively, BMS 1030 analyses measurements receives from CMDs 1020 collectively using measurements obtained by multiple CMDs, for example, by comparing measurements received from one CMD 1020 against measurements received from other CMDs 1020, to determine whether a fault detected by CMD 1020 has occurred.

BMS 1030 communicates determined faults and related data to external systems 1040 and/or IOT cloud 1050 (steps 1033 and 1035 respectively). In some embodiments, BMS 1030 communicates with external systems 1040 and/or IOT cloud 1050 concerning a detected fault with no time shifting, i.e., immediately upon determining that a fault has occurred. In some other embodiments, BMS 1030 time shifts the sharing of data concerning determined faults with external systems 1040, IOT cloud 1050, or both, i.e., there is a delay between BMS 1030 determining a fault at the battery system and communicating information regarding such a fault to external systems 1040, IOT cloud 1050, or both. For example, BMS 1030 may share information about a determined fault with external systems 1040, IOT cloud 1050, or both only after BMS 1030 stores such information locally at BMS 1030. BMS 1030 may also wait to receive a request for a status update on the battery system from external systems 1040, IOT cloud 1050, or both before sharing information about faults detected at the battery system.

BMS 1030 also communicates with external systems 1040, IOT cloud 1050, or both concerning faults determined by CMDs 1020 (steps 1037 and 1039 respectively). In some embodiments, BMS 1030 communicates with external systems 1040 and/or IOT cloud 1050 concerning a fault detected by CMD 1020 immediately upon CMD 1020 transmitting a fault indicator and related fault data to BMS 1030, with no time shifting.

In some other embodiments, BMS 1030 time shifts communications with external systems 1040 and/or IOT cloud 1050 concerning faults detected by CMDs 1020 by having a time delay between receiving respective data from CMDs 1020 and transmitting such data to external systems 1040 and/or IOT cloud 1050. For example, BMS 1030 may store data received from CMDs 120 before passing it on to external systems 1040 and/or IOT cloud 1050. Additionally or alternatively, BMS 1030 may also compare such data to its own analysis of corresponding measurements received from CMDs 1020 to verify faults detected by CMDs 1020 before informing external systems 1040 and/or IOT cloud 1050 about faults detected at the monitored battery system.

Upon receiving data concerning a fault detected at monitored battery systems, external systems 1040 and IOT cloud 1050 identify and effect a corresponding remedial action (steps 1041 and 1051 respectively). Returning to the electric vehicle example, an external system in the form of a vehicle management unit may cause an alert to be displayed on the dashboard of the vehicle or an audible warning to be issued instructing the driver to steer to a safe place, and whereupon instruct the BMS to disconnect the battery from the power source, such as the powertrain. An IOT cloud may determine a degradation hazard fault through analysis of data from multiple battery systems. For example, a fault due to the NOA being set too wide for a particular type of battery cells can be determined by analysing multiple systems with different use profiles. The IOT Cloud can then instruct the external system in the form of the vehicle management unit to modify the vehicle performance NOA, the BMS to change its NOA, and the cell CMDs to change their NOA.

CMDs 1020, BMS 1030, external systems 1040, and IOT cloud 1050 may use different data to determine or confirm faults at monitored cells. For example, BMS 1030 may use data received from multiple CMDs to confirm or determine faults at cells monitored by one of the CMDs, while external system 1040 or IOT cloud 1050 may use data received from multiple BMSs monitoring different batteries. In some circumstances, while CMD 1020 may detect a fault at one or more monitored cells, BMS 1030, external system 1040, or IOT cloud may reach a different conclusion based on data gathered in relation to other cells, such as neighbouring cells. Conversely, while CMD 1020 may detect no fault at one or more monitored cells, BMS 1030, external system 1040, or IOT cloud 1050 may reach a different conclusion based on data gathered in relation to other cells, such as neighbouring cells. For example, BMS 1030, external system 1040, or IOT cloud 1050 may detect a fault at certain cells upon learning that a particular behaviour exhibited by the monitored cells as evidenced by measurements obtained at the monitored cells by the corresponding CMD has led to a fault in similar cells before, notwithstanding that cell measurements were within a corresponding SOA or NOA. In some embodiments, BMS 1030, external system 1040, or IOT cloud 1050 transmits respective data back to CMD 1020 to update locally stored history of faults detected at the respective monitored cells.

### Safe Sleep Mode

Figure 11 illustrates process flows between CMDs 1020, BMS 1030, external systems 1040, and IOT cloud 1050 while BMS 1030 is operating in Safe Sleep mode ON mode 920 and Safe Sleep (polled) Mode 930. Actions taken while BMS 1030 is in Safe Sleep mode 920 are depicted above divider 1160 while actions taken while BMS 1030 is in Safe Sleep (polled) mode are depicted below divider 1160.

Safe Sleep mode 920 is a power saving state of BMS 1030. While in Safe Sleep mode, BMS 1030 is not operated and consumes only minimal power. Therefore, BMS 1030 does not communicate with CMDs 1020, external systems 1040, or IOT cloud 1050.

While BMS 1030 is in Safe Sleep mode 920, each CMD 1020 is in a sleep monitoring mode (also referenced as a monitoring mode). In this mode, CMD 1020 continues to repeatedly measure cell properties (e.g., temperature and voltage) of monitored cells (step 1121) and evaluate the measured cell properties to determine faults, if any, at the monitored cells (step 1123). However, CMD 1020 performs such actions generally less frequently while in the sleep monitoring mode than while in the operational mode. CMD 1020 may measure different properties of monitored cells with different frequencies while in operational mode and reduce such frequencies to different levels while in the sleep monitoring mode. This allows CMD 1020 to continue gathering measurements sufficient to determine faults if any arise at monitored cells, while reducing power consumption by CMD 1020.

For example, CMD 1020 may measure voltage of a monitored group of cells every 10 milliseconds (i.e., with a frequency of 100 Hz) while in the operational mode, and every 500 milliseconds (i.e., with a frequency of 2 Hz) while in the sleep monitoring mode. As another example, CMD 1020 may measure temperature of a monitored cell group or individual cells every 1 second (i.e., with a frequency of 1 Hz) while in the operational mode, and continue to measure temperature of the monitored cell group or individual cells every 1 second (i.e., with a frequency of 1 Hz) while in sleep monitoring mode.

Similar to CMD 400 and 600, the frequency with which CMD 1020 measures various properties of monitored cells may be configurable. For the example, the frequency can be adjusted responsive to measurements obtained at the monitored cells (e.g., voltage, current, temperature, pressure, etc.), a detected state of the monitored cells, measurement trends exhibited by the monitored cells, intended use of the monitored cells, a state of health of the monitored cells, etc.

Similar to the operational mode, if CMD 1020 determines no fault at any of the monitored cells, CMD 1020 returns to measuring step 1121. If CMD 1020 determines a fault at one or more monitored cells, CMD 1020 stores data concerning the detected fault locally at CMD 1020 for later transmission to BMS 1030. Such data comprises a fault indicator and related fault data, including a timestamp indicating when the fault was detected by CMD 1020. Fault data may also include measurements (direct, derivative, or both) based on which CMD 1020 detected the fault. After storing data concerning the detected fault, CMD 1020 returns to measuring step 1121.

Multiple faults may arise at monitored cells, near simultaneously or over time, while BMS 1030 is in Safe Sleep Mode 920. Information concerning all such multiple faults is saved by respective CMDs 1020 in local storage, such as Fault Store 426 or 626, for later communication to BMS 1030.

### Safe Sleep (polled) Mode

Repeatedly (e.g., periodically), BMS 1030 wakes and transitions from Safe Sleep mode 920 to Safe Sleep (polled) mode 930 to assess the state of the monitored battery system (step 1131). In some embodiments, Safe Sleep (polled) mode 930 is initiated at BMS 1030, instead of ON mode 910, when BMS 1030 is powered up.

Once in Safe Sleep (polled) mode 930, BMS 1030 informs CMDs 1020 accordingly, for example, by sending a respective wake-up signal to CMDs 1020 (step 1133) to cause CMDs 1020 to transition from the safe monitoring mode to the operational mode. CMDs 1020 may inform BMS 1030 that they have transitioned into the operational mode by sending a corresponding signal (step 1126).

At step 1135, BMS 1030 requests each CMD 1020 to share data regarding faults detected by CMD 1020, measurements obtained by CMDs 1020, or both. BMS 1030 may request CMDs 1020 to share data related to faults detected by CMDs 1020 during the most recent Safe Sleep mode interval, during a certain number of preceding Safe Sleep mode intervals, or a particular time period. BMS 1030 may also request CMDs 1020 to share data related to all faults detected by CMDs 1020, i.e., the entire history of faults detected by CMDs 1020. For the same time periods, BMS 1030 may request CMDs 1020 to share measurements obtained by CMDs 1020 at corresponding cells, any derived measurements, or both.

In response, each CMD 1020 retrieves respective data from a corresponding local fault store (step 1127) and transmits such data to BMS 1030 (step 1129). CMD 1020 may process the retrieved data prior to transmitting such data to BMS 1030, for example to compress or encrypt the data before transmission. CMD 1020 stores timing information (e.g., in the form of timestamps) in association with the measurements and faults, where the timing information indicates when the measurements were obtained, and faults were detected. Therefore, CMD 1020 is able to retrieve data corresponding to any desired time interval using the timing information indicated by timestamps.

Once CMDs 1020 transmit the requested data to BMS 1030, CMDs 1020 continues to operate in the operational mode as described with reference to Figure 10, until BMS 1030 sends a sleep signal (step 1130), which causes CMDs 1020 to transition to the sleep monitoring mode. In some embodiments, instead of BMS 1030 and CMDs 1020 exchanging wake-up and sleep signals, BMS 1030 and CMDs 1020 transition between respective modes according to a pre-defined schedule or at regular intervals.

At steps 1137 and 1139 BMS 1030 communicates data received from CMDs 1020 concerning detected faults to external systems 1040 and/or IOT cloud 1050, respectively. In some embodiments, BMS 1030 does so immediately upon receiving respective data, with no time shifting. In some other embodiments, BMS 1030 time shifts communications with external systems 1040 and/or IOT cloud 1050 concerning faults detected by CMDs 1020. For example, BMS 1030 may store data received from CMDs 1020 for later retrieval and passing such data on to external systems 1040 and/or IOT cloud 1050.

Additionally or alternatively, BMS 1030 may analyse the measurements received from each CMD 1020 for faults independent of analysis by respective CMD 1020 and compare results of such analysis to information provided by CMDs 1020 to verify faults and faults conditions detected by CMDs 1020 before communicating with external systems 1040 and/or IOT cloud 1050 about faults detected at the monitored cells. BMS 1030 may also analyze measurements receives from CMDs 1020 collectively, using measurements obtained by multiple CMSs, for example by comparing measurements received from one CMD 1020 against measurements received from other CMDs 1020.

Upon receiving data concerning faults detected at the monitored battery cells, external systems 1040 and IOT cloud 1050 identify and effect corresponding remedial actions (steps 1141 and 1151 respectively).

In known systems, an operator starting a vehicle with a battery system monitored by a BMS, powers up a BMS, which causes the BMS to perform a number of checks on monitored battery system (e.g., to confirm that cell measurements are within a respective SOA) before closing a battery system relay to connect the monitored battery system to a power source, such as a charger, or a load such as a powertrain. However, in such systems, the BMS is only aware of the measurements taken when the checks are being performed, and thus may not be aware that a particular cell or cells experienced a fault. For example, although a particular cell may have all its measurements within the SOA at the time of the check, it could have had measurements that fell outside the SOA at some point in time before the vehicle or the other system being started (e.g., a temperature or voltage spike or dip), which indicates that the cell experienced a fault. However, if the BMS is not aware of such measurements, the BMS will proceed with closing the battery system relay, thereby facilitating development of the respective fault.

In accordance with the present disclosure, as for example described with reference to Figures 4 to 11, CMDs detect faults independent of their BMS, store relevant data locally at the CMDs, and make such historical data available to a BMS, such as upon the BMS transitioning into the ON mode or Safe Sleep (polled) mode. Returning to the above electric vehicle scenario, an operator starting a vehicle, having an electric battery comprising cell groups, each cell group having a CMD of this disclosure, powers up a BMS. At that stage, the BMS is able to access cell measurements obtained at the battery system not only at the time of the BMS being powered up, but also cell measurements obtained at times prior to the BMS being powered up. This includes any faults detected by CMDs prior to the BMS being powered up. Thus, in contrast to known systems and in accordance with the present disclosure, the BMS is able to take an immediate remedial action in response to cells experiencing a fault sometime before the BMS being powered up, such as not closing the relay to the powertrain and not allowing the vehicle to start. In this manner, catastrophic faults can be averted.

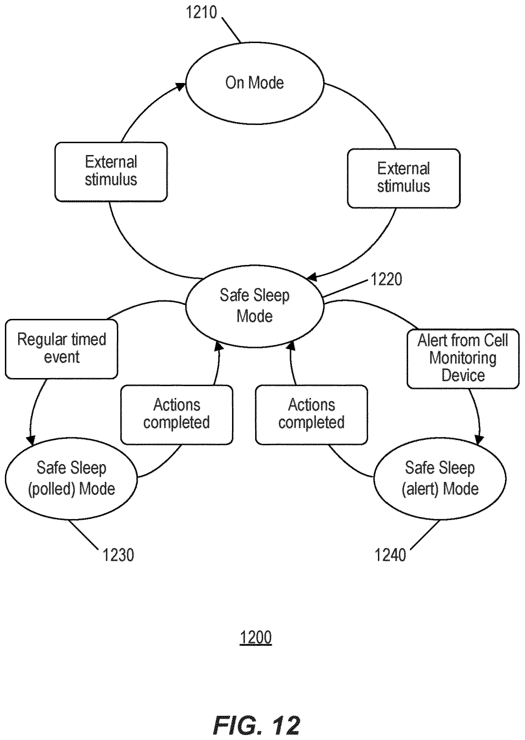

Figure 12 depicts chart 1200 showing operating modes of BMS 1330 adapted for working with CMDs described in this disclosure, according to some embodiments. Descriptions of BMS 430, 730, and 1030 with respect to Figures 4 to 11 is applicable to BMS 1030, with the exception of the differences discussed with reference to Figures 12 to 14.

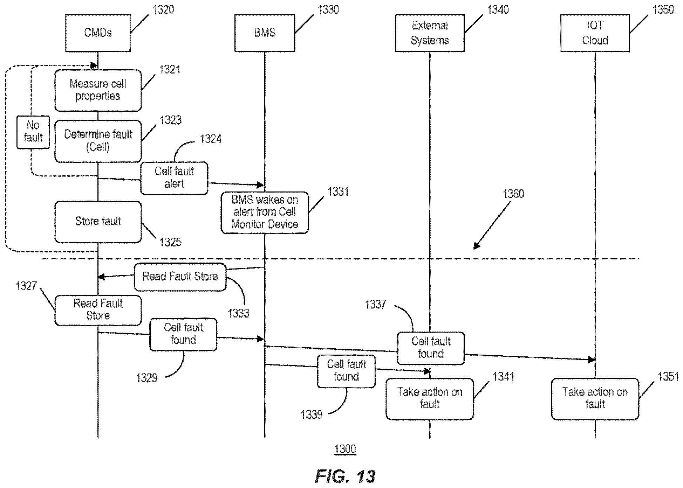

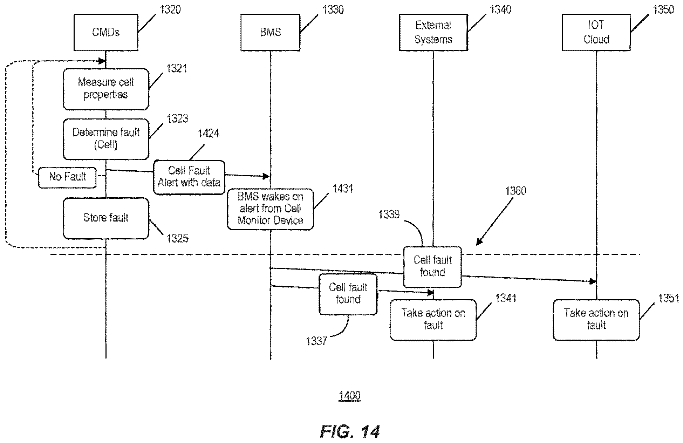

Figures 13 and 14 show process flows 1200 and 1300 in systems for monitoring the state of battery packs or battery systems as described in this disclosure and including a BMS with the operating modes shown in Figure 12, according to some embodiments. Figures 12, 13, and 14 are described with reference to BMS 1330 monitoring the state of a battery system. This description similarly applies to a scenario where multiple BMS 1330 are employed to monitor the state of a battery system, each BMS 1330 monitoring the state of a subset of cells forming the battery system, such as a battery pack.

With reference to Figure 12, BMS 1330 is operable in four modes: ON mode 1210 (first mode), Safe Sleep mode 1220 (second mode), Safe Sleep (polled) mode 1230 (third mode), and Safe Sleep (alert) mode 1240 (fourth mode).

External stimulus activates ON mode 1210 at BMS 1030. For example, if BMS 1330 monitors a battery system in an electric vehicle, turning the key switch or ignition on provides external stimulus that activates ON mode 1210 at BMS 1330. Another external stimulus or removal of the original stimulus transitions BMS 1330 from ON mode 1210 to Safe Sleep mode 1220. In the electric vehicle example, turning the key switch or ignition off removes the original stimulus, thereby causing BMS 1330 to transition to Safe Sleep mode 1220. While in Safe Sleep mode 1220, BMS 1330 is not operated and consumes only minimal power.

Repeatedly (e.g., periodically) BMS 1330 wakes up and transitions from Safe Sleep mode 1220 to Safe Sleep (polled) mode 1230 to assess the state of the monitored battery system or battery pack based on data provided by CMDs 1320. In some embodiments, Safe Sleep (polled) mode 1230 is initiated at BMS 1330, instead of ON mode 1210, when BMS 1330 is powered up.

Upon completing assessment of the monitored battery system and performing related actions, BMS 1330 transitions to Safe Sleep mode 1220. BMS 1330 may wake up from Safe Sleep mode 1220 at regular timed intervals, e.g., every N minutes (e.g., 15 minutes) or every M hours (e.g., 3-4 hours), random timed intervals, or timed intervals determined based on the state of monitored battery system. For example, the time interval may decrease as obtained cell measurements approach the bounds of a respective SOA or NOA and increase, up to a predefined time limit, as obtained cell measurements move further away from the SOA or NOA bounds or when are well within the SOA or NOA bounds.

BMS 1330 transitions to Safe Sleep (alert) mode 1240 from Safe Sleep mode 1210 when BMS 1330 receives an alert signal from CMD 1320 indicating that CMD 1320 detected a fault at one or more monitored cells. In some embodiments, CMD 1320 transmits such an alert to BMS 1330 only when it detects a fault of a predetermined type, for example, a fault having the immediate hazard severity level.

Once in Safe Sleep (alert) mode 1240, BMS 1330 assesses the state of the monitored battery system based on data provided by CMDs 1320 and performs related actions, such as communicating with external systems 1340 and/or IOT cloud 1350 regarding the detected faults. BMS 1330 may then return to Safe Sleep mode 1020.

### ON Mode

While BMS 1330 is in ON Mode 1210, CMDs 1320, BMS 1330, external systems 1340, and IOT cloud 1350 operate in the same manner as CMDs 1020, BMS 1030, external systems 1040, and IOT cloud 1050 respectively, while BMS 1030 is ON Mode 910. Detailed description provided with reference to Figures 9, 10, and 11 in relation to ON mode 910 therefore applies to CMDs 1320, BMS 1330, external systems 1340, and IOT cloud 1350 and is not repeated.

### Safe Sleep (polled) Mode

While BMS 1330 is in Safe Sleep (polled) mode 1230, CMDs 1320, BMS 1330, external systems 1340, and IOT cloud 1350 operate generally in the same manner as CMDs 1020, BMS 1030, external systems 1040, and IOT cloud 1050 respectively, while BMS 1030 is in Safe Sleep (polled) mode 930. Detailed description provided with reference to Figures 9, 10, and 11 in relation to Safe Sleep (polled) mode 930 therefore applies to CMDs 1320, BMS 1330, external systems 1340, and IOT cloud 1350 and not repeated.

### Safe Sleep Mode

While BMS 1330 is in Safe Sleep mode 1220, CMDs 1320, BMS 1330, external systems 1340, and IOT cloud 1350 generally operate in the same manner as CMDs 1020, BMS 1030, external systems 1040, and IOT cloud 1050 respectively, while BMS 1030 is in Safe Sleep mode 920. Detailed description provided with reference to Figures 9, 10, and 11 in relation to Safe Sleep mode 920 therefore applies to CMDs 1320, BMS 1330, external systems 1340, and IOT cloud 1350 and not repeated.

While BMS 1330 is in Safe Sleeping mode 920, CMD 1320 is in a sleep monitoring mode as CMD 1020 described with reference to Figures 9 to 11 and is operable to perform similar actions. Additionally and unlike CMD 1020, CMD 1320 is also operable to issue and transmit an alert signal to BMS 1330 indicating that one or more monitored cells experienced a fault, upon determining such a fault. Responsive to receiving the alert signal, BMS 1330 wakes and transitions from Safe Sleep mode 1220 to Safe Sleep (alert mode) 1240.

Figures 13 and 14 illustrate process flows between CMDs 1320, BMS 1330, external systems 1340, and IOT cloud 1350 while BMS 1330 is in Safe Sleep mode 1220 and Safe Sleep (alert) Mode 1230. Actions taken while BMS 1330 is in Safe Sleep mode 1220 are depicted above divider 1360, while actions taken while BMS 1330 is in Safe Sleep (alert) mode are depicted below divider 1360.

As Safe Sleep mode 920, Safe Sleep mode 1220 is a power saving state of BMS 1330. While in Safe Sleep mode 1220, BMS 1330 is not operated and consumes only minimal power. Therefore, BMS 1330 does not communicate with CMDs 1320, external systems 1340, or IOT cloud 1350. Unlike BMS 1030 of Figures 10 and 11, BMS 1330, however, is operable to receive alert signals from CMDs 1320 while in Safe Sleep mode 1220.

Similar to CMDs 1020, each CMD 1320 is in a sleep monitoring mode while BMS 1330 is in Safe Sleep mode 1220. In this mode, CMD 1320 continues to repeatedly measure cell properties (e.g., temperature and voltage) of monitored cells (step 1321) and evaluate the measured cell properties to determine faults, if any, at the monitored cells (step 1323). If CMD 1320 determines no fault at any of the monitored cells, CMD 1320 returns to measuring step 1321. If CMD 1320 determines a fault at one or more monitored cells, CMD 1320 stores data concerning the detected fault locally at CMD 1320 (step 1325).

Unlike CMDs 1020, CMD 1320 issues and transmits an alert signal to BMS 1330 to indicate that CMD 1320 determined a fault at one or more monitored cells (steps 1324, 1424). The difference between step 1324 shown in Figure 13 and step 1424 shown in Figure 14 is that, at step 1324, CMD 1320 transmits an alert signal only, while at step 1424, CMD 1320 also transmits a corresponding fault indicator and data related to the determined fault, including a relevant timestamp. An alert signal at steps 1324 and 1424 may take the form of a single bit, or include additional data related to the determined fault, e.g., indicate a severity level of the detected fault. At step 1424, the fault indicator may serve as the alert signal, with no separate alert signal being transmitted.

In some embodiments, CMD 1320 issues an alert signal only if the severity level of a determined fault is an immediate hazard, while with faults of other severity levels, CMD 1320 operates as CMD 1020.

BMS 1330 is operable to receive alert signals from CMDs 1320 and transition from Safe Sleep mode 1220 to Safe Sleep (alert) mode 1240 upon receiving such a signal. In some embodiments, BMS transitions from Safe Sleep mode 1220 to Safe Sleep (alert) mode 1240 only if a received alert signal indicates that the severity level of a detected fault is an immediate hazard. In these embodiments, when a received alert signal does not relate to an immediate hazard fault, BMS 1330 delays further communications with CMDs 1320 until BMS 1330 transitions to Safe Sleep (polled) mode.

### Safe Sleep (alert) Mode

With reference to Figure 13, upon transitioning into Safe Sleep (alert) mode 1240, BMS 1330 requests CMD 1320, from which BMS 1330 received the alert signal, to share data concerning the detected fault (step 1333). BMS 1330 may also request CMD 1320 to share data related to faults detected by CMD 1320 during the most recent Safe Sleep mode interval, during a certain number of preceding Safe Sleep mode intervals, or any desired time period. BMS 1330 may request data related to all faults detected by CMD 1320, i.e., the entire fault history stored at CMD 1320. Similarly, BMS 1330 may request CMD 1320 to share measurements obtained by CMD 1320 at its monitored cells during any desired time period.

As BMS transitions to Safe Sleep (alert) mode, CMD 1320 transitions from the sleep monitoring mode to the operational mode. CMD 1320 may transition into the operational mode independently, when sending the alert signal to BMS 1330 or upon receiving a respective command from BMS 1330, or a request for data (fault data, measurements that did not result in detecting of a fault, or both) from BMS 1330. In some embodiments, BMS 1330 sends a wake-up signal to CMD 1320 upon transitioning to Safe Sleep (alert) mode 1240 to cause CMD 1320 to transition into the operational mode.

In response to the received request for data from BMS 1330, CMD 1320 retrieves respective data from a corresponding local fault store (step 1327) and transmits such data to BMS 1330 (step 1329). As CMD 1320 stores timing information, such as timestamps, indicating when measurements were obtained and faults were detected, CMD 1320 can retrieve fault data and measurements corresponding to any desired time interval using the timing information.

CMD 1320 may process the retrieved data prior to transmitting such data to BMS 1330, for example, to compress or encrypt the data before transmission.

Once CMD 1320 transmits the requested data to BMS 1330, CMD 1320 continues to operate in the operational mode as, for example, described with reference to Figures 10 and 11 and CMD 1020, until BMS 1030 sends a sleep signal, which causes CMDs 1320 to return to the sleep monitoring mode.

At steps 1337 and 1339, BMS 1030 communicates data received from CMD 1320 concerning the detected faults and/or measurements taken at the cells monitored by CMD 1320 to external systems 1340 and/or IOT cloud 1350, respectively. In some embodiments, BMS 1330 does so immediately upon receiving respective data, with no time shifting.

In some other embodiments, BMS 1330 time shifts communications with external systems 1340 and/or IOT cloud 1350 concerning the fault detected by CMD 1320. For example, BMS 1330 first may store data received from CMD 1320 for later retrieval and passing on of such data to external systems 1340 and/or IOT cloud 1350. In some embodiments, BMS 1330 transmits data concerning faults detected at the monitored battery system to external systems 1340 and/or IOT cloud 1350 upon receiving a respective request from external systems 1340 and/or IOT cloud 1350.

In some embodiments, upon receiving an alert signal from one CMD 1320 and transitioning into Safe Sleep (alert) mode 1240, BMS 1330 transmits a wake-up signal to remaining CMDs 1320 to transition them into the operational mode. This causes remaining CMDs 1320 to share their data concerning any faults detected at the corresponding cells. BMS 1330 may then analyze measurements received from CMDs 1320 collectively, for example by comparing measurements received from CMD 1320 that issued the alert signal against relevant measurements received from remaining CMDs 1320 to verify the fault detected by CMD 1320 that issued the alert signal. Additionally or alternatively, BMS 1330 may analyze the measurements received from each CMD 1320 for faults independent of analysis by respective CMD 1320 and compare results of such analysis to information provided by CMDs 1320 concerning detected faults to verify faults and faults conditions detected by CMDs 1320.

Upon receiving data concerning faults detected at the monitored battery cells, external systems 1340 and IOT cloud 1350 identify and effect corresponding remedial actions (steps 1341 and 1351 respectively). As external systems 1340 and IOT cloud 1350 receive data from multiple BMSs, and thus have a greater number of data points, they are able to identify systematic causes of faults and differentiate them from random faults more accurately than respective BMSs. BMS 1330 usually would only have knowledge of the behaviour of a battery pack BMS 1330 monitors. A behavioural fault may affect all cells in that pack and could be triggered by a systematic problem in all cells in a respective manufactured batch. Because all cells in the battery pack behave in the same way, BMS 1330 does not have data that would enable BMS 1330 to identify the cell behaviour as incorrect. However external systems 1340 and IOT cloud 1350 are able to compare the behaviour with other similar packs, and thus identify any errant behaviour.

For example, an entire batch of cells, due to a manufacturing defect, have an internal resistance that increases over time. Eventually, the internal resistance will lead to a failure of a battery pack. Because all cells in the battery pack have the same problem, the pack internal resistance increases slowly over time, but not in a manner that causes concern. However, when compared to other packs manufactured at a different time the increase in internal resistance will be viewed as unusual, and thus indicative of a fault. This comparison is best performed at a location common to multiple battery packs, such as at external systems 1340 or IOT cloud 1350.

Upon identifying unusual behaviour of certain battery packs, the IOT Cloud 1350 may inform external system 1340. External system 1340 can a similar observation and decide to remove the battery packs of concern from operation, or reduce their duty cycle to reduce degradation, or simply notify relevant operator.

Process flows of Figure 14 differ from process flows of Figure 13 in that, according to Figure 14, CMD 1320 transmits data related to a fault detected by CMD 1320 in addition to an alert signal regarding the detected fault (step 1424). Since BMS 1330 receives data relevant to the determined fault together with the alert signal, BMS 1330 does not need to request such data from CMD 1320. The remaining steps in Figure 14 are the same as corresponding steps of Figure 13, and thus their description is not repeated.

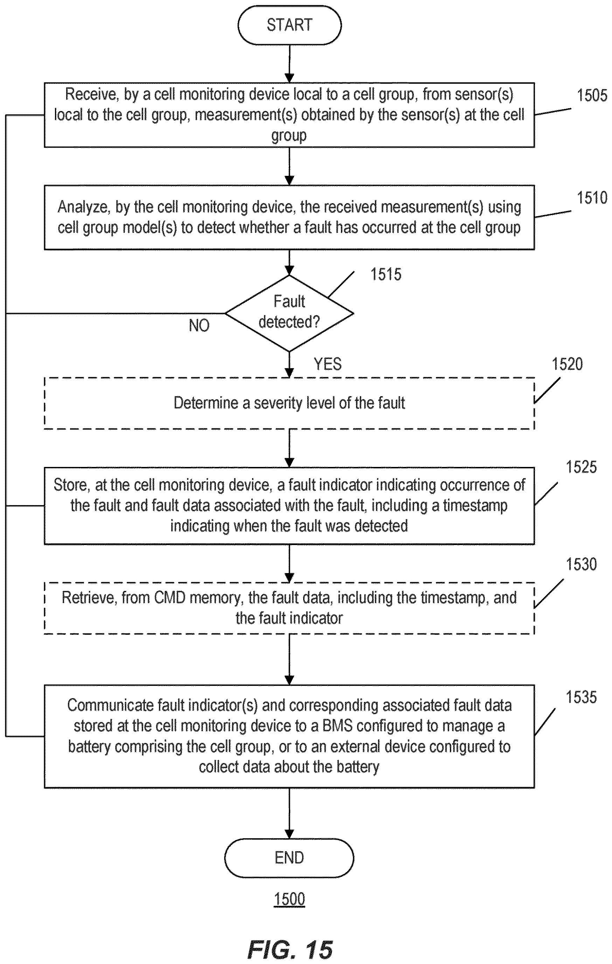

Figure 15 depicts a flowchart of method 1500 for monitoring the state of a cell group, according to some embodiments. Although described with reference to CMD 400 and BMS 430 any of CMD and BMS variations described throughout this applications can be involved in method 1500, such as CMD 600, 720, 1020, or 1320 and BMS 630, 730, 1030, or 1330, and described with reference to Figures 4 to 14.

The cell group includes one or more cells. In some embodiments, the cell group includes a single cell, or a plurality of cells connected in parallel.

CMD 400 is operable to monitor the state of the cell group, including for any faults arising at one or more cells of the cell group by measuring one or more properties of one or more cells in the cell group or the cell group as a whole, or both. CMD 400 may be operable to measure electrical, physical, or chemical properties of one or more cells or the cell group, or any combination thereof, using corresponding sensors. CMD 400 may also be operable to measure properties of the environment surrounding the cell group using corresponding one or more sensors and use such measurements when evaluating the measurements obtained at the cell group for potential faults.

CMD 400 is local to the cell group. For example, CMD 400 may be attached to the cell group, incorporated with the cell group (e.g., incorporated with a housing hosting the cell group), integrated with or within a cell in the cell group, or otherwise connected to the cell group so as to monitor the state of cells in the cell group.

At step 1505, CMD 400 receives one or measurements obtained at the cell group by one or more sensors. As discussed, for example, with reference to Figures 4 to 6, CMD 400 may employ a sensor system including different sensing elements adapted to measure physical properties, electrical properties, chemical properties, environmental properties, or any combination thereof of monitored cell(s) and corresponding conditioning circuitry that converts the output of the one or more sensing elements into an analogue signal suitable for conversion by an ADC.

CMD 400 includes one or more cell models configured to receive sensor measurements as input and to output a result of determining whether corresponding one or more cells or the group of cells experienced a fault based on the inputted measurements. Example cell models are described elsewhere in this disclosure, for example, with reference to Figures 4 to 6. At step 1510, CMD 400 processes the received measurement(s) using corresponding one or more cell models to determine whether the cell group experienced a fault. If CMD 400 detects no fault, method 1500 returns to step 1505.

As discussed with reference to Figures 9 - 14, CMD constantly measures cell properties and evaluates such measurements to determine whether any of the monitored cells experienced a fault, notwithstanding whether CMD 400 is in communication or connected to BMS 430 or an external device. The frequency with which CMD 400 returns to step 1505 may vary, for example, depending on whether CMD 400 is in an operational mode or in a sleep monitoring mode, the type of property or properties being measured, how proximate the recent measurements are to SOA or NOA boundaries of the cell group, state of health of cells in the cell group, etc, or any combination thereof.

Upon determining a fault, CMD 400 may determine a severity level of the determined fault at step 1520. Details of classifying faults according to severity levels and various examples of both are described with reference to Figures 5A to 5N.

At step 1525, CMD 400 stores locally, for example, in memory of CMD (such as fault store 426 or 626), a fault indicator indicating that the cell group experienced a fault, and related fault data. The fault data at least includes a timing information, such as a timestamp, indicating when the fault was determined by CMD 400. The fault data may also include sensor measurements (actual, derived, or a combination of both) that led CMD to determine the fault.

At step 1530, CMD 400 retrieves, from its memory, one or more fault indicators and related fault data, including the fault indicator and related fault data. As described, for example, with reference to Figures 9 to 14, CMD 400 may retrieve one or more fault indicators and related fault data in response to a corresponding request for status update received from BMS configured to manage a battery system comprising the cell group, or received from an external device configured to collect data about the battery system.

At step 1535, CMD 400 communicates the retrieved one or more fault indicators and related fault data to BMS or the external device. CMD 400 may also retrieve, from its memory, and communicate measurements of cell properties that have been obtained at the monitored cells but did not result in the CMD 400 detecting a fault.

Upon completion of step 1535, the method returns to step 1505.

In some embodiments, CMD 400 may store and communicate a fault indicator and related fault data in parallel, or communicate the fault indicator and related fault data prior to storing the same in memory of CMD 400.

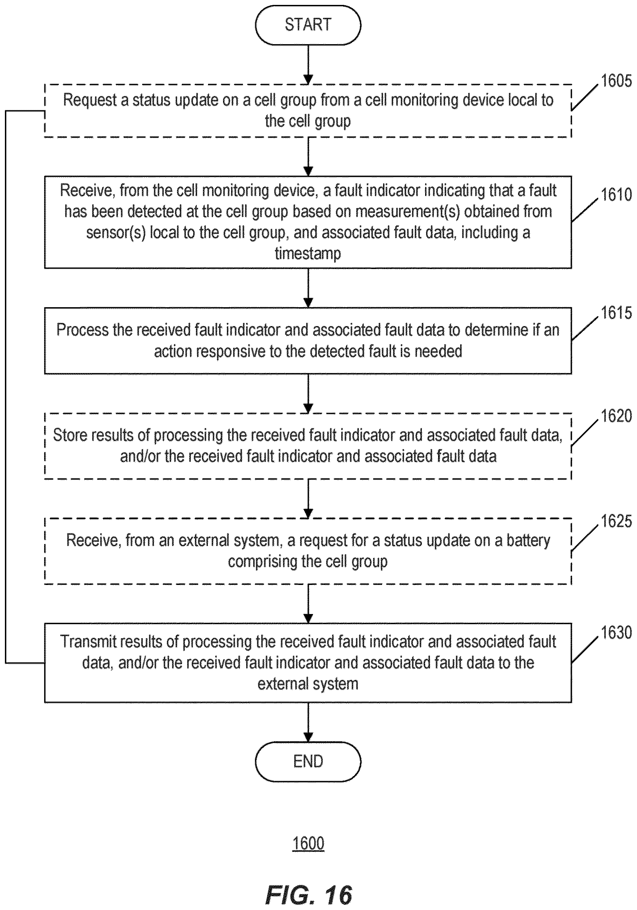

Figure 16 shows a method for monitoring a state of a battery system according to some embodiments. Although described with reference to BMS 430 and CMD 400, any of CMD and BMS variations described throughout this applications can be involved in method 1600, such as BMS 630, 730, 1030, or 1330, and CMD 600, 720, 1020, or 1320, described with reference to Figures 4 to 14. Further, although method 1600 is described in the context of monitoring the state of a battery system, the method is similarly applicable to monitoring a state of a plurality of cell groups, for example, a plurality of cell groups that form a battery system or a subset of a battery system.

Method 1600 starts with step 1605 at which BMS 430 requests status update on a cell group, from CMD 400 associated with the cell group. For example, as discussed with reference to Figures 9 to 14, BMS 430 may repeatedly transition from safe sleep mode 920, 1220 to safe sleep (polled) mode 930, 1230 to monitor the status of one or more cell groups. Upon transitioning into safe sleep (polled) mode 930,1230, BMS 430 requests, status update on monitored cell groups from corresponding CMDs 400 of the cell groups. BMS 430 may request each CMD 400 to include in their response to the status update: all faults determined by CMD 400 at the cell group since the previous status update received by BMS from that CMD 400, all faults determined by CMD 400 at the cell group during a particular time period, all faults determined by CMD 400 at the cell group during the lifetime of CMD 400, or all faults determined by CMD 400 at the cell group while BMS 430 was powered off, inactive, or otherwise incommunicado with CMD 400. BMS 430 may also request each CMD 400 to provide cell property measurements obtained during the same time periods that did not result in CMD detecting a fault.

In some embodiments, CMD alerts BMS about a detected fault, upon detecting such a faut. Method 1600 may then start with BMS 430 receiving an alert from CMD 400 that CMD 400 detected a fault. For example, as discussed with reference to Figures 11 to 14, BMS 430 may transition from safe sleep mode 1220 mode to safe sleep (alert) mode 1240 upon receiving, from CMD 400, an alert indicating that CMD 400 determined a fault at the corresponding cell group. Responsive to the alert and to receive data related to the detected fault, BMS 430 proceeds with step 1605 at which BMS 430 requests a status update from CMD 400, for example, upon transitioning into safe sleep (alert) mode 1230.

In some embodiments, the alert may include or be accompanied by a fault indicator and fault data. In such embodiments, BMS 430 does not need to request CMD 400 for relevant data, and method 1600 instead starts with step 1610, which serves to alert BMS 430 that CMD 400 detected a fault.

Method 1600 may also start with step 1610, instead of step 1605, when CMD 400 transmits status updates, including fault indicator(s) and related fault data to BMS 430 according to a predefined schedule, as for example discussed with reference to Figures 11 to 14,

At step 1610, BMS 430 receives, from CMD 400, a fault indicator and related fault data. The fault indicator indicates that CMD 400 detected or determined a fault at the cell group based on measurement(s) obtained at the cell group by respective sensors of CMD 400. The fault indicator may also identify the fault, include a severity level of the fault, or both.

The fault data includes a timing information, such as a timestamp, indicating when CMD 400 determined the fault. The fault data may also include sensor measurement(s) obtained by CMD 400 at the cell group and used to determine the fault, measurements derived from the sensor measurement, or both. CMD 400 may send the fault indicator and related fault data responsive to the request sent by BMS 430 at step 1605.

The status update sent by CMD 400 may include all faults determined by CMD 400 at the cell group since the previous status update sent by CMD 400, all faults determined by CMD 400 at the cell group during a particular time period, all faults determined by CMD 400 at the cell group over the lifetime of CMD 400 or the cell group, or all faults determined by CMD 400 at the cell group while BMS 430 was powered off, or inactive, or otherwise incommunicado with CMD 400. The status update sent by CMD 400 may also include cell property measurements obtained during the same time periods or derivatives of such measurements, or both that did not result in CMD 400 detecting any faults.

At step 1615, BMS 430 processes the received fault indicator and related fault data to determine if an action responsive to the detected fault is needed. For example, the action may be BMS 430 updating the status of the battery system to fault condition and transmitting the data received from CMD 400 to an external system

As discussed with reference to Figures 9 to 14, BMS 430 may analyse the received fault data using corresponding cell model(s) stored at BMS 430 to confirm determination by CMD 400 that the cell group experienced the fault.

Alternatively or additionally, as also discussed with reference to Figures 9 to 14, the BMS may request a status update on one or more other cell groups from respective one or more other CMDs 400 and, upon receiving the status update, analyse the fault data received from first CMD 400 in combination with data included in the status update received from one or more other CMDs 400 monitoring the one or more other cell groups to confirm that first cell group experienced the fault. The one or more other cell groups may be cell groups adjacent to the first cell group, a selected number of cell groups monitored by BMS 430, or all other cell groups monitored by BMS 430.

At step 1620, BMS 430 stores results of processing the received fault indicator and related fault data. For example, BMS 430 may update the status of the battery system to indicate that it experienced a fault or is in fault condition, a type of the fault, where the fault originated, and other relevant data. Additionally or alternatively, BMS 430 stores the received fault indicator and related fault data.

At step 1625, BMS 430 may receive, from an external system, a request for a status update on the battery system comprising the cell group. At step 1630, BMS 430 transmits results of processing the received fault indicator and related fault data and/or the fault indicator and related fault data received from CMD 400 to the external system.

The BMS may repeat steps 1605 to 1630 for all CMDs 400 monitoring the status of battery cells forming the battery system.

The descriptions of the various embodiments of the present disclosure have been presented for purposes of illustration and are not intended to be exhaustive or limiting to the scope of the disclosure. Many modifications and variations of the disclosed embodiments will be apparent to those of ordinary skill in the art from the herein disclosed embodiments, without departing from the scope of the disclosure. The terminology used herein to disclose the embodiments of the disclosure was chosen to best explain the principles of the embodiments, the practical application or technical improvement over technologies found in the marketplace, or to enable others of ordinary skill in the art to understand the embodiments disclosed herein.

It is appreciated that certain features of the disclosure, which are, for clarity, described in the context of separate embodiments, may also be provided in combination in a single embodiment. Conversely, various features of the disclosure, which are, for brevity, described in the context of a single embodiment, may also be provided separately or in any suitable sub-combination or as suitable in any other described embodiment of the disclosure. Certain features described in the context of various embodiments are not to be considered essential features of those embodiments unless the embodiment is inoperative without those elements.

Although the disclosure has been described in conjunction with specific embodiments thereof, it is evident that many alternatives, modifications, and variations will be apparent to those skilled in the art. Accordingly, it is intended to embrace all such alternatives, modifications and variations that fall within the scope of the appended claims.

## Claims

1. A method for monitoring a battery by a battery management system, BMS, the battery comprising a plurality of cell groups, each cell group comprising one or more battery cells and a corresponding cell monitoring device, CMD, the method comprising:
receiving (1610), by the BMS (730, 1030, 1330) from a first CMD (400, 600, 720₁, 1020, 1320) of a first cell group (712i) in the plurality of cell groups (712₁, 712₂, 712₃, 712₄, 712_{N}), a fault indicator and fault data stored (1125, 1325) at the first CMD, wherein:
the fault indicator indicates that the first CMD determined a fault at the first cell group based on one or more measurements of cell properties obtained at one or more cells in the first cell group by at least one sensor (411, 611) of the first CMD,
the fault data relates to the determined fault and comprises a timestamp indicating when the first CMD determined the fault; and
processing (1615) by the BMS the received fault indicator and fault data to determine an action responsive to the fault determined by the first CMD independently of whether the first CMD was connected to the BMS or in communication with BMS.

2. The method of claim 1, comprising:
receiving, by the BMS, a command to connect the battery to a power source;
checking, by the BMS, a status of the battery prior to connecting the battery to the power source, wherein checking the status comprises the steps of receiving and processing the fault indicator and the fault data; and
rejecting, by the BMS, the command to connect the battery to the power source responsive to processing the received fault indicator and fault data; and
optionally, issuing an alert that the battery is experiencing a fault condition.

3. The method of claim 1 or 2, wherein the fault data comprises at least one measurement used by the first CMD to determine the fault, the at least one measurement comprising one or more of a measurement obtained at the first cell group or a measurement derived based on one or more measurements obtained at the first cell group.

4. The method of any of claims 1 to 3, wherein the fault indicator indicates one or more of: the fault or a severity level of the fault, the severity level being one of an immediate hazard, a delayed hazard, or a degradation hazard.

5. The method of any of claims 1 to 4, wherein processing the received fault indicator and fault data comprises storing, at the BMS, the fault indicator and the related fault data received from the first CMD, the method comprising:
receiving, from an external system, a request for a status update of the battery; and
transmitting the status update of the battery to the external system, the status update comprising the fault indicator and the related fault data stored at the BMS.

6. The method of any of claims 1 to 5, wherein processing the received fault indicator and fault data comprises:
using one or more cell models, stored at the BMS and corresponding to the one or more cells of the first cell group, with the received fault data to confirm that the first cell group experienced the fault.

7. The method of any of claims 1 to 6, wherein processing the received fault indicator and fault data comprises:
receiving a status update on a second cell group in the plurality of cell groups, from a CMD of the second cell group, the status update comprising at least one of:
one or more measurements of one or more cell properties of one or more cells in the second cell group obtained by at least one sensor of the second CMD, or
fault data related to one or more faults determined by the second CMD at the second cell group, the fault data comprising one or more timestamps indicating when the second CMD determined respectively the one or more faults; and
comparing the fault data received from the first CMD with data included in the status update received from the second CMD to confirm that first cell group experienced the fault.

8. The method of claim 7, comprising:
transmitting, upon receiving the fault indicator and fault data from the first CMD, a status request to the second CMD,
wherein the status update on the second cell group is received by the BMS in response to the status request.

9. The method of claim 7 or 8, wherein the second cell group comprises one or more cells adjacent to the first cell group or wherein the method comprises repeating the receiving and comparing steps for each cell group of the plurality of cell groups.

10. The method of any of claims 1 to 9,
wherein the fault indicator indicating that the first CMD determined that first cell group experienced the fault and the related fault data are received from the first CMD of the first cell group as a part of a status update provided by the first CMD to the BMS, wherein the status update is received by the BMS periodically, at a prescheduled time, or in response to a status update request sent by the BMS to the first CMD; and
wherein the status update of the first CMD comprises one or more fault indicators and related fault data concerning one or more of:
all faults determined by the first CMD at the first cell group since a previous status update received by the BMS from the first CMD,
all faults determined by the first CMD at the first cell group during a predefined time period,
all faults determined by the first CMD at the first cell group, or
one or more faults determined by the first CMD at the first cell group while the BMS was powered off or inactive.

11. The method of any of claims 1 to 10, wherein the BMS is in a sleep mode prior to receiving the fault indicator and the related fault data from the first CMD, the method comprising:
receiving, by the BMS in the sleep mode, an alert signal from the first CMD indicating that the first CMD detected the fault;
responsive to alert signal, transitioning the BMS from the sleep mode to an active mode to process the fault indicator and related fault data,
optionally wherein the fault determined by the first CMD is classified by the CMD as an immediate hazard.

12. The method of claim 11, comprising:
responsive to the alert signal, transmitting a status update request from the BMS to the first CMD, wherein the fault indicator and related fault data are received from the first CMD responsive to the status update request.

13. The method of any of claims 1 to 12, the measurements obtained at the first cell group and received by the BMS as the fault data comprise one or more of:
a voltage detected at the first cell group,
a temperature detected externally to the cell group,
a temperature at the first cell group,
a temperature at a cell or within the cell of the first cell group,
a gas pressure within a cell of the first cell group,
a force exerted by a cell of the first cell group on an external surface of the cell,
a deflection of a cell enclosure of a cell in the first cell group caused by a change of internal pressure,
a humidity level at the first cell group or at a cell in the first cell group,
a predetermined chemical indicative of cell damage, or
a current flowing through the first cell group or through a cell in the first cell group.

14. The method of any of claims 1 to 13, wherein the fault determined at the first cell group is an operational fault or a behavioural fault,
the operational fault being determined when performance of the first cell group is determined to fall outside of a safe operating area defined by predetermined safe operational limits or outside of a normal operating area defined by predetermined normal operational limits, wherein the safe and normal operational limits correspond to the measurements obtained at the first cell group and are defined by a cell model corresponding to the first cell group, and
the behavioural fault being determined when performance of the first cell group deviates from expected performance of the first cell group by a deviation greater than a predefined threshold, the expected performance of the first cell group being defined by at least one of: a cell model corresponding to the first cell group or performance of one or more neighbouring cell groups in the plurality of cell groups determined based on measurements obtained by local sensors at the one or more neighbouring cell groups.

15. The method of claim 14,
wherein the operational fault is determined when the measurements obtained at the first cell group meet one or more of conditions:
a current flowing through the first cell group exceeds a maximum charge current predefined for the one or more battery cells in the first cell group,
a current flowing through the first cell group exceeds a maximum discharge current predefined for the one or more battery cells in the first cell group,
a temperature taken at the cell group is below a minimum operational temperature predefined for the one or more battery cells in the cell group,
the temperature taken at the cell group exceeds a maximum operational temperature predefined for the one or more battery cells in the first cell group,
a cell terminal voltage of the one or more battery cells in the cell group exceeds a maximum operational voltage predefined for the one or more battery cells in the cell group,
the cell terminal voltage of the one or more battery cells in the cell group is below a minimum operational voltage predefined for the one or more battery cells in the cell group,
a cell pressure of the one or more battery cells in the cell group exceeds a maximum operational pressure predefined for the one or more battery cells in the cell group, or
a cell pressure of the one or more battery cells in the cell group is below a minimum operational pressure predefined for the one or more battery cells in the cell group;
and
wherein the behavioural fault is determined when the measurements obtained at the first cell group meet at least one of the following conditions:
a rate of change of temperature at the first cell group is greater or less than a thermo-electrical model of the first cell group for a known stimulus and a current state of the first cell group, or
a rate of change of pressure at the first cell group is greater or less than a thermo-electrical model of the first cell group for a known stimulus and a current state of the first cell group, or
a rate of change of voltage at the first cell group is greater or less than a thermo-electrical model of the first cell group for a known stimulus and a current state of the first cell group.

16. The method of claim 14, comprising:
receiving, by the BMS, measurements obtained at one or more cell groups neighbouring the first group by corresponding one or more neighbouring CMDs, the measurements obtained at the one more neighbouring cell groups corresponding to the measurements obtained at the first cell group and received from the one or more neighbouring CMDs,
wherein the behavioural fault is determined when a change, or a rate of change, determined in one or more measurements obtained at the first cell group over a period of time deviates from a change, or a rate of change respectively, determined in corresponding one or more measurements obtained at the one or more neighbouring cell groups over the same period of time by a deviation greater than a corresponding threshold, when the first cell group and the one or more neighbouring cell groups are exposed to the same stimulus.

17. A computer-readable medium storing instructions which, when executed by at least one processor of a Battery Management System, BMS, cause the BMS (730, 1030, 1330) to perform the method of any of claims 1 to 16.

18. A method for monitoring a cell group by a cell monitoring device, CMD, the cell group comprising one or more battery cells, the method comprising:
receiving (1505), by the CMD (400, 600, 720₁, 1020, 1320) of the cell group, from at least one sensor (411, 611) configured to measure one or more properties of the cell group, at least one measurement obtained by the at least one sensor, the CMD comprising at least one cell model of the cell group configured for the cell group;
processing (1510) the received at least one measurement by the CMD using a corresponding cell model of the cell group to determine whether the cell group experienced a fault;
in response to determining a first fault at the cell group, storing (1525) in memory of the CMD, a fault indicator, indicating that the cell group experienced the first fault, and fault data related to the first fault, the fault data comprising a timestamp generated when the first fault was determined by the CMD, retrieving (1530), from the memory of the CMD, one or more fault indicators and corresponding fault data, including the fault indicator and the fault data related to the first fault, each fault indicator indicating that the cell group experienced a corresponding fault; and
communicating (1535), by the CMD to a battery management system, BMS, configured to manage a battery comprising the cell group, the retrieved one or more fault indicators and corresponding fault data,
wherein the CMD performed the receiving, processing, and storing steps independently of the BMS and whether the CMD was connected to the BMS (730, 1030, 1330) or in communication with BMS.

19. The method of claim 18, wherein for each determined fault, the related fault data comprise at least one of: one or more sensor measurements the CMD used to determine the fault, or one or more derived measurements the CMD used to detect the fault, and/or wherein for each determined fault, the fault indicator identifies the fault.

20. The method of claim 18 or 19, further comprising: determining (1520), based on the received at least one measurement, a severity level of the first fault, the severity level being one of an immediate hazard, a delayed hazard, or a degradation hazard, optionally wherein the fault indicator of the first fault identifies the severity level of the first fault.

21. The method of claim 20, wherein determining the severity level of the first fault comprises: upgrading the severity level of the first fault from the delayed hazard to an immediate hazard or from the degradation hazard to an immediate hazard when the CMD determined the first fault within a predefined time period after determining one or more other faults at the cell group.

22. The method of any of claims 18 to 21, comprising: repeating the receiving and processing steps by the CMD when no fault is determined at the cell group and/or repeating the receiving, processing, and storing steps by the CMD to detect a plurality of faults.

23. The method of claim 22, wherein the receiving and processing steps are repeated with a varied frequency depending at least on one of: whether the CMD is in a first mode or a second mode, or a type of at least one measurement.

## Patentansprüche

1. Verfahren zum Überwachen einer Batterie durch ein Batteriemanagementsystem, BMS, wobei die Batterie eine Vielzahl von Zellgruppen umfasst, wobei jede Zellgruppe eine oder mehrere Batteriezellen und eine entsprechende Zellüberwachungsvorrichtung, CMD, umfasst, wobei das Verfahren Folgendes umfasst:
Empfangen (1610), durch das BMS (730, 1030, 1330) von einer ersten CMD (400, 600, 720₁, 1020, 1320) einer ersten Zellgruppe (712₁) in der Vielzahl von Zellgruppen (712₁, 712₂, 712₃, 712₄, 712_{N}), eines Fehlerindikators und von Fehlerdaten, die in der ersten CMD gespeichert (1125, 1325) sind, wobei:
der Fehlerindikator angibt, dass die erste CMD einen Fehler an der ersten Zellgruppe basierend auf einer oder mehreren Messungen von Zelleigenschaften, die an einer oder mehreren Zellen in der ersten Zellgruppe durch zumindest einen Sensor (411, 611) der ersten CMD erhalten werden, bestimmt hat,
sich die Fehlerdaten auf den bestimmten Fehler beziehen und einen Zeitstempel umfassen, der angibt, wann die erste CMD den Fehler bestimmt hat; und
Verarbeiten (1615), durch das BMS, des empfangenen Fehlerindikators und der Fehlerdaten, um eine Handlung als Reaktion auf den Fehler, der durch die erste CMD bestimmt wird, zu bestimmen, unabhängig davon, ob die erste CMD mit dem BMS verbunden oder in Kommunikation mit dem BMS war.

2. Verfahren nach Anspruch 1, umfassend:
Empfangen, durch das BMS, eines Befehls zum Verbinden der Batterie mit einer Stromquelle;
Überprüfen, durch das BMS, eines Status der Batterie vor dem Verbinden der Batterie mit der Stromquelle, wobei das Überprüfen des Status die Schritte des Empfangens und Verarbeitens des Fehlerindikators und der Fehlerdaten umfasst; und
Ablehnen, durch das BMS, des Befehls zum Verbinden der Batterie mit der Stromquelle als Reaktion auf Verarbeiten des empfangenen Fehlerindikators und der empfangenen Fehlerdaten; und
optional Ausgeben einer Warnung, dass die Batterie einen Fehlerzustand erlebt.

3. Verfahren nach Anspruch 1 oder 2, wobei die Fehlerdaten zumindest eine Messung umfassen, die durch die erste CMD verwendet wird, um den Fehler zu bestimmen, wobei die zumindest eine Messung eines oder mehrere von einer Messung, die an der ersten Zellgruppe erhalten wird, oder einer Messung, die basierend auf einer oder mehreren Messungen, die an der ersten Zellgruppe erhalten werden, abgeleitet ist, umfasst.

4. Verfahren nach einem der Ansprüche 1 bis 3, wobei der Fehlerindikator eines oder mehrere von Folgendem angibt: dem Fehler oder einem Schweregrad des Fehlers, wobei der Schweregrad eines von einer unmittelbaren Gefahr, einer verzögerten Gefahr oder einer Verschlechterungsgefahr ist.

5. Verfahren nach einem der Ansprüche 1 bis 4, wobei das Verarbeiten des empfangenen Fehlerindikators und der empfangenen Fehlerdaten Speichern, an dem BMS, des Fehlerindikators und der zugehörigen Fehlerdaten, die von der ersten CMD empfangen werden, umfasst, wobei das Verfahren Folgendes umfasst:
Empfangen, von einem externen System, einer Anforderung für eine Statusaktualisierung der Batterie; und
Übertragen der Statusaktualisierung der Batterie an das externe System, wobei die Statusaktualisierung den Fehlerindikator und die zugehörigen Fehlerdaten, die in dem BMS gespeichert sind, umfasst.

6. Verfahren nach einem der Ansprüche 1 bis 5, wobei das Verarbeiten des empfangenen Fehlerindikators und der empfangenen Fehlerdaten Folgendes umfasst:
Verwenden von einem oder mehreren Zellmodellen, die in dem BMS gespeichert sind und der einen oder den mehreren Zellen der ersten Zellgruppe entsprechen, mit den empfangenen Fehlerdaten, um zu bestätigen, dass die erste Zellgruppe den Fehler erlebt hat.

7. Verfahren nach einem der Ansprüche 1 bis 6, wobei das Verarbeiten des empfangenen Fehlerindikators und der empfangenen Fehlerdaten Folgendes umfasst:
Empfangen einer Statusaktualisierung zu einer zweiten Zellgruppe in der Vielzahl von Zellgruppen von einer CMD der zweiten Zellgruppe, wobei die Statusaktualisierung zumindest eines von Folgendem umfasst:
einer oder mehreren Messungen von einer oder mehreren Zelleigenschaften von einer oder mehreren Zellen in der zweiten Zellgruppe, die durch zumindest einen Sensor der zweiten CMD erhalten werden, oder
Fehlerdaten, die sich auf einen oder mehrere Fehler beziehen, die durch die zweite CMD in der zweiten Zellgruppe bestimmt werden, wobei die Fehlerdaten einen oder mehrere Zeitstempel umfassen, die angeben, wann die zweite CMD jeweils den einen oder die mehreren Fehler bestimmt hat; und
Vergleichen der Fehlerdaten, die von der ersten CMD empfangen werden, mit Daten, die in der Statusaktualisierung beinhaltet sind, die von der zweiten CMD empfangen werden, um zu bestätigen, dass die erste Zellgruppe den Fehler erlebt hat.

8. Verfahren nach Anspruch 7, umfassend:
Übertragen, nach Empfangen des Fehlerindikators und der Fehlerdaten von der ersten CMD, einer Statusanforderung an die zweite CMD,
wobei die Statusaktualisierung zu der zweiten Zellgruppe durch das BMS als Reaktion auf die Statusanforderung empfangen wird.

9. Verfahren nach Anspruch 7 oder 8, wobei die zweite Zellgruppe eine oder mehrere Zellen benachbart zu der ersten Zellgruppe umfasst oder wobei das Verfahren Wiederholen der Schritte des Empfangens und Vergleichens für jede Zellgruppe aus der Vielzahl von Zellgruppen umfasst.

10. Verfahren nach einem der Ansprüche 1 bis 9,
wobei der Fehlerindikator angibt, dass die erste CMD bestimmt hat, dass die erste Zellgruppe den Fehler erlebt hat, und die zugehörigen Fehlerdaten von der ersten CMD der ersten Zellgruppe als Teil einer Statusaktualisierung empfangen werden, die durch die erste CMD an das BMS bereitgestellt wird, wobei die Statusaktualisierung durch das BMS regelmäßig, zu einer vorab festgelegten Zeit oder als Reaktion auf eine Statusaktualisierungsanforderung, die durch das BMS an die erste CMD gesendet wird, empfangen wird; und
wobei die Statusaktualisierung der ersten CMD einen oder mehrere Fehlerindikatoren und zugehörige Fehlerdaten betreffend eines oder mehrere von Folgendem umfasst:
allen Fehlern, die durch die erste CMD in der ersten Zellgruppe seit einer vorherigen Statusaktualisierung bestimmt werden, die durch das BMS von der ersten CMD empfangen wird,
allen Fehlern, die durch die erste CMD in der ersten Zellgruppe während eines vorbestimmten Zeitraums bestimmt werden,
allen Fehlern, die durch die erste CMD in der ersten Zellgruppe bestimmt werden, oder
einem oder mehreren Fehlern, die durch die erste CMD in der ersten Zellgruppe bestimmt werden, während das BMS ausgeschaltet oder inaktiv war.

11. Verfahren nach einem der Ansprüche 1 bis 10, wobei das BMS in einem Ruhemodus ist, bevor es den Fehlerindikator und die zugehörigen Fehlerdaten von der ersten CMD empfängt, wobei das Verfahren Folgendes umfasst:
Empfangen, durch das BMS in dem Ruhemodus, eines Warnsignals von der ersten CMD, das angibt, dass die erste CMD den Fehler erfasst hat;
als Reaktion auf das Warnsignal Überführen des BMS von dem Ruhemodus in einen aktiven Modus, um den Fehlerindikator und die zugehörigen Fehlerdaten zu verarbeiten,
wobei optional der Fehler, der durch die erste CMD bestimmt wird, durch die CMD als unmittelbare Gefahr klassifiziert wird.

12. Verfahren nach Anspruch 11, umfassend:
als Reaktion auf das Warnsignal Übertragen einer Statusaktualisierungsanforderung von dem BMS an die erste CMD, wobei der Fehlerindikator und die zugehörigen Fehlerdaten von der ersten CMD als Reaktion auf die Statusaktualisierungsanforderung empfangen werden.

13. Verfahren nach einem der Ansprüche 1 bis 12, wobei die Messungen, die an der ersten Zellgruppe erhalten und durch das BMS als die Fehlerdaten empfangen werden, eines oder mehrere von Folgendem umfassen:
einer Spannung, die an der ersten Zellgruppe erfasst wird,
einer Temperatur, die außerhalb der Zellgruppe erfasst wird,
einer Temperatur an der ersten Zellgruppe,
einer Temperatur an einer Zelle oder innerhalb der Zelle der ersten Zellgruppe,
einem Gasdruck innerhalb einer Zelle der ersten Zellgruppe,
einer Kraft, die durch eine Zelle der ersten Zellgruppe auf eine externe Oberfläche der Zelle ausgeübt wird,
einer Auslenkung einer Zellhülle einer Zelle in der ersten Zellgruppe bewirkt durch eine Änderung von Innendruck,
einem Feuchtigkeitsgrad an der ersten Zellgruppe oder an einer Zelle in der ersten Zellgruppe,
einer vorbestimmten Chemikalie, die Zellschaden angibt, oder
einem Strom, der durch die erste Zellgruppe oder durch eine Zelle in der ersten Zellgruppe fließt.

14. Verfahren nach einem der Ansprüche 1 bis 13, wobei der Fehler, der an der ersten Zellgruppe bestimmt wird, ein Betriebsfehler oder ein Verhaltensfehler ist,
wobei der Betriebsfehler bestimmt wird, wenn bestimmt wird, dass Leistung der ersten Zellgruppe außerhalb eines sicheren Betriebsbereichs fällt, der durch vorbestimmte sichere Betriebsgrenzen definiert ist, oder außerhalb eines normalen Betriebsbereichs, der durch vorbestimmte normale Betriebsgrenzen definiert ist, wobei die sicheren und normalen Betriebsgrenzen den Messungen entsprechen, die an der ersten Zellgruppe erhalten werden und durch ein Zellmodell definiert sind, das der ersten Zellgruppe entspricht, und
der Verhaltensfehler bestimmt wird, wenn Leistung der ersten Zellgruppe von erwarteter Leistung der ersten Zellgruppe um eine Abweichung abweicht, die größer als ein vordefinierter Schwellenwert ist, wobei die erwartete Leistung der ersten Zellgruppe durch zumindest eines von Folgendem definiert ist: einem Zellmodell, das der ersten Zellgruppe entspricht, oder Leistung von einer oder mehreren benachbarten Zellgruppen in der Vielzahl von Zellgruppen, die basierend auf Messungen bestimmt wird, die durch lokale Sensoren an der einen oder den mehreren benachbarten Zellgruppen erhalten werden.

15. Verfahren nach Anspruch 14,
wobei der Betriebsfehler bestimmt wird, wenn die Messungen, die an der ersten Zellgruppe erhalten werden, eine oder mehrere der folgenden Bedingungen erfüllen:
ein Strom, der durch die erste Zellgruppe fließt, überschreitet einen maximalen Ladestrom, der für die eine oder mehreren Batteriezellen in der ersten Zellgruppe vordefiniert ist,
ein Strom, der durch die erste Zellgruppe fließt, überschreitet einen maximalen Entladestrom, der für die eine oder mehreren Batteriezellen in der ersten Zellgruppe vordefiniert ist,
eine Temperatur, die an der Zellgruppe genommen wird, ist unter einer Mindestbetriebstemperatur, die für die eine oder mehreren Batteriezellen in der Zellgruppe vordefiniert ist,
die Temperatur, die an der Zellgruppe genommen wird, überschreitet eine maximale Betriebstemperatur, die für die eine oder mehreren Batteriezellen in der ersten Zellgruppe vordefiniert ist,
eine Zellklemmenspannung der einen oder mehreren Batteriezellen in der Zellgruppe überschreitet eine maximale Betriebsspannung, die für die eine oder mehreren Batteriezellen in der Zellgruppe vordefiniert ist,
die Zellklemmenspannung der einen oder mehreren Batteriezellen in der Zellgruppe ist unter einer Mindestbetriebsspannung, die für die eine oder mehreren Batteriezellen in der Zellgruppe vordefiniert ist,
ein Zelldruck von der einen oder den mehreren Batteriezellen in der Zellgruppe überschreitet einen maximalen Betriebsdruck, der für die eine oder mehreren Batteriezellen in der Zellgruppe vordefiniert ist, oder
ein Zelldruck von der einen oder den mehreren Batteriezellen in der Zellgruppe ist unter einem Mindestbetriebsdruck, der für die eine oder mehreren Batteriezellen in der Zellgruppe vordefiniert ist;
und
wobei der Verhaltensfehler bestimmt wird, wenn die Messungen, die an der ersten Zellgruppe erhalten werden, zumindest eine der folgenden Bedingungen erfüllen:
eine Änderungsrate der Temperatur an der ersten Zellgruppe ist größer oder kleiner als ein thermoelektrisches Modell der ersten Zellgruppe für einen bekannten Reiz und einen aktuellen Zustand der ersten Zellgruppe, oder
eine Änderungsrate des Drucks an der ersten Zellgruppe ist größer oder kleiner als ein thermoelektrisches Modell der ersten Zellgruppe für einen bekannten Reiz und einen aktuellen Zustand der ersten Zellgruppe, oder
eine Änderungsrate der Spannung an der ersten Zellgruppe ist größer oder kleiner als ein thermoelektrisches Modell der ersten Zellgruppe für einen bekannten Reiz und einen aktuellen Zustand der ersten Zellgruppe.

16. Verfahren nach Anspruch 14, umfassend:
Empfangen, durch das BMS, von Messungen, die an einer oder mehreren Zellgruppen benachbart zu der ersten Gruppe durch entsprechende eine oder mehrere benachbarte CMDs erhalten werden, wobei die Messungen, die an der einen oder den mehreren benachbarten Zellgruppen erhalten werden, den Messungen entsprechen, die an der ersten Zellgruppe erhalten und von der einen oder den mehreren benachbarten CMDs empfangen werden,
wobei der Verhaltensfehler bestimmt wird, wenn eine Änderung oder eine Änderungsrate, die in einer oder mehreren Messungen bestimmt wird, die an der ersten Zellgruppe über einen Zeitraum erhalten werden, jeweils von einer Änderung oder einer Änderungsrate, die in entsprechenden einer oder mehreren Messungen bestimmt wird, die an der einen oder den mehreren benachbarten Zellgruppen über denselben Zeitraum erhalten werden, um eine Abweichung, die größer als ein entsprechender Schwellenwert ist, wenn die erste Zellgruppe und die eine oder mehreren benachbarten Zellgruppen demselben Reiz ausgesetzt sind, abweicht.

17. Computerlesbares Medium, das Anweisungen speichert, die, wenn sie durch zumindest eine Prozessor eines Batteriemanagementsystems, BMS, ausgeführt werden, bewirken, dass das BMS (730, 1030, 1330) das Verfahren nach einem der Ansprüche 1 bis 16 durchführt.

18. Verfahren zum Überwachen einer Zellgruppe durch eine Zellüberwachungsvorrichtung, CMD, wobei die Zellgruppe eine oder mehrere Batteriezellen umfasst, wobei das Verfahren Folgendes umfasst:
Empfangen (1505), durch die CMD (400, 600, 720₁, 1020, 1320) der Zellgruppe, von zumindest einem Sensor (411, 611), der konfiguriert ist, um eine oder mehrere Eigenschaften der Zellgruppe zu messen, von zumindest einer Messung, die durch den zumindest einen Sensor erhalten wird, wobei die CMD zumindest ein Zellmodell der Zellgruppe umfasst, das für die Zellgruppe konfiguriert ist;
Verarbeiten (1510) der empfangenen zumindest einen Messung durch die CMD unter Verwendung eines entsprechenden Zellmodells der Zellgruppe, um zu bestimmen, ob die Zellgruppe einen Fehler erlebt hat;
als Reaktion auf das Bestimmen eines ersten Fehlers in der Zellgruppe, Speichern (1525), in Speicher der CMD, eines Fehlerindikators, der angibt, dass die Zellgruppe den ersten Fehler erlebt hat, und von Fehlerdaten, die sich auf den ersten Fehler beziehen, wobei die Fehlerdaten einen Zeitstempel umfassen, der erzeugt wurde, als der erste Fehler durch die CMD bestimmt wurde, Abrufen (1530), aus dem Speicher der CMD, von einem oder mehreren Fehlerindikatoren und entsprechenden Fehlerdaten, beinhaltend den Fehlerindikator und die Fehlerdaten, die sich auf den ersten Fehler beziehen, wobei jeder Fehlerindikator angibt, dass die Zellgruppe einen entsprechenden Fehler erlebt hat; und
Kommunizieren (1535), durch die CMD an ein Batteriemanagementsystem, BMS, das konfiguriert ist, um eine Batterie zu verwalten, welche die Zellgruppe umfasst, der abgerufenen einen oder mehreren Fehlerindikatoren und entsprechenden Fehlerdaten,
wobei die CMD die Schritte des Empfangens, Verarbeitens und Speicherns unabhängig von dem BMS, und ob die CMD mit dem BMS (730, 1030, 1330) verbunden oder in Kommunikation mit dem BMS war, durchgeführt hat.

19. Verfahren nach Anspruch 18, wobei für jeden bestimmten Fehler die zugehörigen Fehlerdaten zumindest eines von Folgendem umfassen: einer oder mehreren Sensormessungen, welche die CMD verwendet hat, um den Fehler zu bestimmen, oder einer oder mehreren abgeleiteten Messungen, welche die CMD verwendet hat, um den Fehler zu erfassen, und/oder wobei für jeden bestimmten Fehler der Fehlerindikator den Fehler identifiziert.

20. Verfahren nach Anspruch 18 oder 19, ferner umfassend: Bestimmen (1520), basierend auf der empfangenen zumindest einen Messung, eines Schweregrads des ersten Fehlers, wobei der Schweregrad eines von einer unmittelbaren Gefahr, einer verzögerten Gefahr oder einer Verschlechterungsgefahr ist, wobei optional der Fehlerindikator des ersten Fehlers den Schweregrad des ersten Fehlers identifiziert.

21. Verfahren nach Anspruch 20, wobei das Bestimmen des Schweregrads des ersten Fehlers Folgendes umfasst: Hochstufen des Schweregrads des ersten Fehlers von der verzögerten Gefahr zu einer unmittelbaren Gefahr oder von der Verschlechterungsgefahr zu einer unmittelbaren Gefahr, wenn die CMD den ersten Fehler innerhalb eines vordefinierten Zeitraums nach dem Bestimmen von einem oder mehreren anderen Fehlern in der Zellgruppe bestimmt hat.

22. Verfahren nach einem der Ansprüche 18 bis 21, umfassend: Wiederholen der Schritte des Empfangens und Verarbeitens durch die CMD, wenn kein Fehler an der Zellgruppe bestimmt wird, und/oder Wiederholen der Schritte des Empfangens, Verarbeitens und Speicherns durch die CMD, um eine Vielzahl von Fehlern zu erfassen.

23. Verfahren nach Anspruch 22, wobei die Schritte des Empfangens und Verarbeitens mit einer variierten Häufigkeit wiederholt werden, abhängig von zumindest einem von: ob die CMD in einem ersten Modus oder einem zweiten Modus ist, oder einer Art von zumindest einer Messung.

## Revendications

1. Procédé de surveillance d'une batterie par un système de gestion de batterie, BMS, la batterie comprenant une pluralité de groupes de cellules, chaque groupe de cellules comprenant une ou plusieurs cellules de batterie et un dispositif de surveillance de cellules, CMD, correspondant, le procédé comprenant :
la réception (1610), par le BMS (730, 1030, 1330) en provenance d'un premier CMD (400, 600, 720₁, 1020, 1320) d'un premier groupe de cellules (712₁) dans la pluralité de groupes de cellules (712₁, 712₂, 712₃, 712₄, 712_{N}), d'un indicateur de défaillance et de données de défaillance stockées (1125, 1325) au niveau du premier CMD :
ledit indicateur de défaillance indiquant que le premier CMD a déterminé une défaillance au niveau du premier groupe de cellules sur la base d'une ou plusieurs mesures de propriétés de cellules obtenues au niveau d'une ou plusieurs cellules dans le premier groupe de cellules par au moins un capteur (411, 611) du premier CMD,
lesdites données de défaillance concernant la défaillance déterminée et comprenant un horodatage indiquant le moment où le premier CMD a déterminé la défaillance ; et
le traitement (1615) par le BMS de l'indicateur de défaillance et des données de défaillance reçus pour déterminer une action en réponse à la défaillance déterminée par le premier CMD indépendamment du fait que le premier CMD soit connecté au BMS ou en communication avec le BMS.

2. Procédé selon la revendication 1, comprenant :
la réception, par le BMS, d'une commande pour connecter la batterie à une source d'alimentation ;
la vérification, par le BMS, de l'état de la batterie avant de connecter la batterie à la source d'alimentation, ladite vérification de l'état comprenant les étapes de réception et de traitement de l'indicateur de défaillance et des données de défaillance ; et
le rejet, par le BMS, de la commande de connexion de la batterie à la source d'alimentation en réponse au traitement de l'indicateur de défaillance et des données de défaillance reçus ; et
éventuellement, l'émission d'une alerte indiquant que la batterie rencontre une condition de défaillance.

3. Procédé selon la revendication 1 ou 2, lesdites données de défaillance comprenant au moins une mesure utilisée par le premier CMD pour déterminer le défaillance, ladite au moins une mesure comprenant une ou plusieurs mesures parmi une mesure obtenue au niveau du premier groupe de cellules ou une mesure dérivée sur la base d'une ou plusieurs mesures obtenues au niveau du premier groupe de cellules.

4. Procédé selon l'une quelconque des revendications 1 à 3, ledit indicateur de défaillance indiquant un ou plusieurs éléments parmi : la défaillance ou le niveau de gravité de la défaillance, le niveau de gravité étant l'un parmi un danger immédiat, un danger différé ou un danger de dégradation.

5. Procédé selon l'une quelconque des revendications 1 à 4, ledit traitement de l'indicateur de défaillance et des données de défaillance reçus comprenant le stockage, au niveau du BMS, de l'indicateur de défaillance et des données de défaillance associées reçus du premier CMD, le procédé comprenant :
la réception, à partir d'un système externe, d'une demande de mise à jour d'état de la batterie ; et
la transmission de la mise à jour d'état de la batterie au système externe, la mise à jour d'état comprenant l'indicateur de défaillance et les données de défaillance associées stockées au niveau du BMS.

6. Procédé selon l'une quelconque des revendications 1 à 5, ledit traitement de l'indicateur de défaillance et des données de défaillance reçus comprenant :
l'utilisation d'un ou plusieurs modèles de cellules, stockés au niveau du BMS et correspondant à une ou plusieurs cellules du premier groupe de cellules, avec les données de défaillance reçues pour confirmer que le premier groupe de cellules a subi la défaillance.

7. Procédé selon l'une quelconque des revendications 1 à 6, ledit traitement de l'indicateur de défaillance et des données de défaillance reçus comprenant :
la réception d'une mise à jour d'état sur un second groupe de cellules dans la pluralité de groupes de cellules, en provenance d'un CMD du second groupe de cellules, la mise à jour d'état comprenant au moins un élément parmi :
une ou plusieurs mesures d'une ou plusieurs propriétés de cellules d'une ou plusieurs cellules dans le second groupe de cellules obtenues par au moins un capteur du second CMD, ou
des données de défaillance associées à une ou plusieurs défaillances déterminées par le second CMD au niveau du second groupe de cellules, les données de défaillance comprenant un ou plusieurs horodatages indiquant quand le second CMD a déterminé respectivement lesdites une ou plusieurs défaillances ; et
la comparaison des données de défaillance reçues du premier CMD avec les données comprises dans la mise à jour d'état reçue du second CMD pour confirmer que le premier groupe de cellules a subi la défaillance.

8. Procédé selon la revendication 7, comprenant :
la transmission, lors de la réception de l'indicateur de défaillance et des données de défaillance du premier CMD, d'une demande d'état au second CMD,
ladite mise à jour d'état sur le second groupe de cellules étant reçue par le BMS en réponse à la demande d'état.

9. Procédé selon la revendication 7 ou 8, ledit second groupe de cellules comprenant une ou plusieurs cellules adjacentes au premier groupe de cellules ou ledit procédé comprenant la répétition des étapes de réception et de comparaison pour chaque groupe de cellules de la pluralité de groupes de cellules.

10. Procédé selon l'une quelconque des revendications 1 à 9,
ledit indicateur de défaillance indiquant que le premier CMD a déterminé que le premier groupe de cellules a subi la défaillance et les données de défaillance associées sont reçues du premier CMD du premier groupe de cellules dans le cadre d'une mise à jour d'état fournie par le premier CMD au BMS, ladite mise à jour d'état étant reçue par le BMS périodiquement, à un moment préprogrammé, ou en réponse à une demande de mise à jour d'état envoyée par le BMS au premier CMD ; et
ladite mise à jour d'état du premier CMD comprenant un ou plusieurs indicateurs de défaillance et des données de défaillance associées concernant un ou plusieurs éléments parmi :
toutes les défaillances déterminées par le premier CMD au niveau du premier groupe de cellules depuis une mise à jour d'état précédente reçue par le BMS à partir du premier CMD,
toutes les défaillances déterminées par le premier CMD au niveau du premier groupe de cellules pendant une période de temps prédéfinie,
toutes les défaillances déterminées par le premier CMD au niveau du premier groupe de cellules, ou
une ou plusieurs défaillances déterminées par le premier CMD au niveau du premier groupe de cellules alors que le BMS était hors tension ou inactif.

11. Procédé selon l'une quelconque des revendications 1 à 10, ledit BMS étant en mode veille avant de recevoir l'indicateur de défaillance et les données de défaillance associées du premier CMD, le procédé comprenant :
la réception, par le BMS en mode veille, d'un signal d'alerte du premier CMD indiquant que le premier CMD a détecté la défaillance ;
en réponse au signal d'alerte, le passage du BMS du mode veille au mode actif pour traiter l'indicateur de défaillance et les données de défaillance associées,
éventuellement ladite défaillance déterminée par le premier CMD étant classée par le CMD en tant que danger immédiat.

12. Procédé selon la revendication 11, comprenant :
en réponse au signal d'alerte, la transmission d'une demande de mise à jour d'état du BMS au premier CMD, ledit indicateur de défaillance et lesdites données de défaillance associées étant reçus du premier CMD en réponse à la demande de mise à jour d'état.

13. Procédé selon l'une quelconque des revendications 1 à 12, lesdites mesures obtenues au niveau du premier groupe de cellules et reçues par le BMS en tant que données de défaillance comprenant un ou plusieurs éléments parmi :
une tension détectée au niveau du premier groupe de cellules,
une température détectée à l'extérieur du groupe de cellules,
une température au niveau du premier groupe de cellules,
une température au niveau d'une cellule ou à l'intérieur de la cellule du premier groupe de cellules,
une pression de gaz à l'intérieur d'une cellule du premier groupe de cellules,
une force exercée par une cellule du premier groupe de cellules sur une surface externe de la cellule,
une déviation d'une enceinte de cellule d'une cellule du premier groupe de cellules provoquée par un changement de pression interne,
un taux d'humidité au niveau du premier groupe de cellules ou d'une cellule du premier groupe de cellules,
un produit chimique prédéfini indiquant des dommages aux cellules, ou
un courant circulant à travers le premier groupe de cellules ou à travers une cellule dans le premier groupe de cellules.

14. Procédé selon l'une quelconque des revendications 1 à 13, ladite défaillance déterminée au niveau du premier groupe de cellules étant une défaillance de fonctionnement ou une défaillance de comportement,
ladite défaillance de fonctionnement étant déterminée lorsque les performances du premier groupe de cellules sont déterminées comme se situant en dehors d'une zone de fonctionnement sûre définie par des limites de fonctionnement sûres prédéfinies ou en dehors d'une zone de fonctionnement normale définie par des limites de fonctionnement normales prédéfinies, lesdites limites de fonctionnement sûres et normales correspondant aux mesures obtenues au niveau du premier groupe de cellules et étant définies par un modèle de cellule correspondant au premier groupe de cellules, et
ladite défaillance de comportement étant déterminée lorsque les performances du premier groupe de cellules s'écartent des performances attendues du premier groupe de cellules d'un écart supérieur à un seuil prédéfini, les performances attendues du premier groupe de cellules étant définies par au moins un élément parmi : un modèle de cellule correspondant au premier groupe de cellules ou les performances d'un ou plusieurs groupes de cellules voisins dans la pluralité de groupes de cellules déterminées sur la base de mesures obtenues par des capteurs locaux au niveau desdits un ou plusieurs groupes de cellules voisins.

15. Procédé selon la revendication 14,
ladite défaillance de fonctionnement étant déterminée lorsque les mesures obtenues au niveau du premier groupe de cellules remplissent une ou plusieurs des conditions :
un courant circulant à travers le premier groupe de cellules dépasse le courant de charge maximal prédéfini pour une ou plusieurs cellules de batterie dans le premier groupe de cellules,
un courant circulant à travers le premier groupe de cellules dépasse le courant de décharge maximal prédéfini pour une ou plusieurs cellules de batterie dans le premier groupe de cellules,
une température mesurée au niveau du groupe de cellules est inférieure à la température de fonctionnement minimale prédéfinie pour une ou plusieurs cellules de batterie dans le groupe de cellules,
la température relevée au niveau du groupe de cellules dépasse la température de fonctionnement maximale prédéfinie pour une ou plusieurs cellules de batterie dans le premier groupe de cellules,
une tension aux bornes de cellule d'une ou plusieurs cellules de batterie du groupe de cellules dépasse la tension de fonctionnement maximale prédéfinie pour une ou plusieurs cellules de batterie dans le groupe de cellules,
la tension aux bornes de cellule desdites une ou plusieurs cellules de batterie du groupe de cellules est inférieure à la tension de fonctionnement minimale prédéfinie pour lesdites une ou plusieurs cellules de batterie dans le groupe de cellules,
une pression de cellule desdites une ou plusieurs cellules de batterie du groupe de cellules dépasse la pression de fonctionnement maximale prédéfinie pour les une ou plusieurs cellules de batterie dans le groupe de cellules, ou
une pression de cellule d'une ou de plusieurs cellules de batterie dans le groupe de cellules est inférieure à la pression de fonctionnement minimale prédéfinie pour une ou plusieurs cellules de batterie dans le groupe de cellules ;
et
ladite défaillance de comportement étant déterminée lorsque les mesures obtenues au niveau du premier groupe de cellules remplissent au moins l'une des conditions suivantes :
un taux de variation de température au niveau du premier groupe de cellules est supérieur ou inférieur à un modèle thermoélectrique du premier groupe de cellules pour un stimulus connu et un état courant du premier groupe de cellules, ou
un taux de variation de pression au niveau du premier groupe de cellules est supérieur ou inférieur à un modèle thermoélectrique du premier groupe de cellules pour un stimulus connu et un état courant du premier groupe de cellules, ou
un taux de variation de tension au niveau du premier groupe de cellules est supérieur ou inférieur à un modèle thermoélectrique du premier groupe de cellules pour un stimulus connu et un état courant du premier groupe de cellules.

16. Procédé selon la revendication 14, comprenant :
la réception, par le BMS, de mesures obtenues au niveau d'un ou plusieurs groupes de cellules voisins du premier groupe en faisant correspondre un ou plusieurs CMD voisins, les mesures obtenues au niveau dudit au moins un groupe de cellules voisins correspondant aux mesures obtenues au niveau du premier groupe de cellules et reçues desdits un ou plusieurs CMD voisins,
ladite défaillance de comportement étant déterminée lorsqu'une variation, ou un taux de variation, déterminé dans une ou plusieurs mesures obtenues au niveau du premier groupe de cellules sur une période de temps s'écarte d'une variation, ou d'un taux de variation respectivement, déterminé dans une ou plusieurs mesures correspondantes obtenues au niveau desdits un ou plusieurs groupes de cellules voisins sur la même période de temps par un écart supérieur à un seuil correspondant, lorsque le premier groupe de cellules et lesdits un ou plusieurs groupes de cellules voisins sont exposés au même stimulus.

17. Support lisible par ordinateur stockant des instructions qui, lorsqu'elles sont exécutées par au moins un processeur d'un système de gestion de batterie, BMS, amènent le système BMS (730, 1030, 1330) à réaliser le procédé selon l'une quelconque des revendications 1 à 16.

18. Procédé de surveillance d'un groupe de cellules par un dispositif de surveillance de cellules, CMD, le groupe de cellules comprenant une ou plusieurs cellules de batterie, le procédé comprenant :
la réception (1505), par le CMD (400, 600, 720₁, 1020, 1320) du groupe de cellules, en provenance d'au moins un capteur (411, 611) configuré pour mesurer une ou plusieurs propriétés du groupe de cellules, d'au moins une mesure obtenue par ledit au moins un capteur, le CMD comprenant au moins un modèle de cellule du groupe de cellules configuré pour le groupe de cellules ;
le traitement (1510) de ladite au moins une mesure reçue par le CMD à l'aide d'un modèle de cellule correspondant du groupe de cellules pour déterminer si le groupe de cellules a subi une défaillance ;
en réponse à la détermination d'une première défaillance au niveau du groupe de cellules, le stockage (1525) dans la mémoire du CMD, d'un indicateur de défaillance, indiquant que le groupe de cellules a subi la première défaillance, et de données de défaillance associées à la première défaillance, les données de défaillance comprenant un horodatage généré lorsque la première défaillance a été déterminée par le CMD, la récupération (1530), à partir de la mémoire du CMD, d'un ou plusieurs indicateurs de défaillance et des données de défaillance correspondantes, comprenant l'indicateur de défaillance et les données de défaillance associées à la première défaillance, chaque indicateur de défaillance indiquant que le groupe de cellules a subi une défaillance correspondante ; et
la communication (1535), par le CMD à un système de gestion de batterie, BMS, configuré pour gérer une batterie comprenant le groupe de cellules, desdits un ou plusieurs indicateurs de défaillance récupérés et des données de défaillance correspondantes,
ledit CMD effectuant les étapes de réception, de traitement et de stockage indépendamment du BMS et que le CMD soit connecté au BMS (730, 1030, 1330) ou en communication avec le BMS.

19. Procédé selon la revendication 18,
pour chaque défaillance déterminée, lesdites données de défaillance associées comprenant au moins une mesure parmi : une ou plusieurs mesures de capteur que le CMD a utilisé pour déterminer la défaillance,
ou une ou plusieurs mesures dérivées que le CMD a utilisé pour détecter la défaillance, et/ou pour chaque défaillance déterminée, l'indicateur de défaillance identifie la défaillance.

20. Procédé selon la revendication 18 ou 19, comprenant en outre : la détermination (1520), sur la base de ladite au moins une mesure reçue, du niveau de gravité de la première défaillance, le niveau de gravité étant l'un parmi un danger immédiat, un danger différé ou un danger de dégradation, éventuellement ledit indicateur de défaillance de la première défaillance identifiant le niveau de gravité de la première défaillance.

21. Procédé selon la revendication 20, ladite détermination du niveau de gravité de la première défaillance comprenant : la mise à niveau du niveau de gravité de la première défaillance du danger retardé à un danger immédiat ou du danger de dégradation à un danger immédiat lorsque le CMD a déterminé la première défaillance dans une période de temps prédéfinie après avoir déterminé une ou plusieurs autres défaillances au niveau du groupe de cellules.

22. Procédé selon l'une quelconque des revendications 18 à 21, comprenant : la répétition des étapes de réception et de traitement par le CMD lorsqu'aucune défaillance n'est déterminée au niveau du groupe de cellules et/ou la répétition des étapes de réception, de traitement et de stockage par le CMD pour détecter une pluralité de défaillances.

23. Procédé selon la revendication 22, lesdites étapes de réception et de traitement étant répétées avec une fréquence variable en fonction d'au moins un élément parmi : si le CMD se trouve dans un premier mode ou un second mode, ou le type d'au moins une mesure.
